# FASCICULE DE BREVET EUROPEEN

(11) **EP 3 729 478 B1**
(45) Date de publication et mention de la délivrance du brevet: **07.06.2023**
(21) Numéro de dépôt: 18833279.5
(22) Date de dépôt: 12.12.2018
(51) Int. Cl.: H01F 6/06, H01F 27/28, H01F 27/32, H01L 39/16

(54) **DIPÔLE LIMITEUR DE COURANT À SUPRACONDUCTEUR, COMPORTANT AU MOINS QUATRE CÂBLES SUPRACONDUCTEURS**
SUPRALEITENDER STROMBEGRENZENDER DIPOL MIT MINDESTENS VIER SUPRALEITENDEN KABELN
SUPERCONDUCTING CURRENT LIMITING DIPOLE, COMPRISING AT LEAST FOUR SUPERCONDUCTING CABLES

(30) Priorité: 22.12.2017 FR 1763092
(43) Date de publication de la demande: 28.10.2020
(73) Titulaire: Supergrid Institute, 69100 Villeurbanne (FR); Institut Polytechnique de Grenoble, 38000 Grenoble (FR)
(72) Inventeur: LEGENDRE, Pierre, 69007 Lyon (FR); TIXADOR, Pascal, 69007 Lyon (FR)
(74) Mandataire: Opilex
(86) Numéro de dépôt international: PCT/FR2018/053225
(87) Numéro de publication internationale: WO 2019/122608

(56) Documents cités:
- CN-A- 103 117 145
- CN-B- 102 592 774
- JP-A- H03 226 228
- US-A- 2011 116 198

## Description

L'invention a trait au domaine des limiteurs de courant à supraconducteur, destinés à des applications sous haute tension.

Ces limiteurs de courant, qui peuvent être résistifs, comportent un conducteur de type supraconducteur et sont, en fonctionnement normal, très faiblement résistifs. Lorsqu'un défaut électrique a pour conséquence une importante augmentation de la densité de courant dans le conducteur, ou lorsque ce dernier n'est plus suffisamment refroidi, le conducteur perd ses propriétés supraconductrices et le limiteur de courant devient fortement résistif, maintenant ainsi le courant en dessous d'une certaine valeur.

La longueur du conducteur de type supracoducteur nécessaire au limiteur de courant est proportionnelle à la tension du réseau ou dispositif à protéger. Elle atteint plusieurs centaines de mètres, voire des kilomètres, pour un limiteur de courant prévu pour la haute tension. Les limiteurs de courant sont donc de préférence enroulés de manière compacte pour limiter l'encombrement d'un tel dispositif qui peut néanmoins atteindre plusieurs mètres de diamètre.

Les documents EP0503448, EP0935261, et US2011/0116198 décrivent un limiteur de courant comportant un conducteur supraconducteur enroulé sensiblement sous forme d'une spirale pour former une bobine bifilaire s'étendant selon un plan unique.

L'invention a pour but d'améliorer les limiteurs de courant de l'art antérieur en proposant un agencement optimisé pour un conducteur supraconducteur et pour ses terminaux de connexion, et ce pour des tensions de l'ordre de 50 à 2000 kV et des courants nominaux de l'ordre de 1000 A à 10000 A.

A cet effet, l'invention vise un dipôle limiteur de courant à supraconducteur, dont les deux bornes sont constituées par un premier terminal de connexion électrique et un deuxième terminal de connexion électrique, ce dipôle limiteur de courant comportant un conducteur de type supraconducteur enroulé pour former une bobine bifilaire s'étendant selon un plan unique, une couche d'isolant étant disposée entre deux spires de ladite bobine. Ledit conducteur de type supraconducteur est constitué d'au moins quatre câbles supraconducteurs distincts enroulés parallèlement et agencés selon au moins deux paires, chacune des paires étant formée de deux desdits câbles supraconducteurs, les câbles supraconducteurs étant reliés entre eux de sorte que le conducteur de type supraconducteur s'étende selon au moins deux allers-retours entre la périphérie et le centre de la bobine en reliant le premier terminal de connexion électrique au deuxième terminal de connexion électrique.

Selon une caractéristique préférée, chacune des paires est formée d'un premier et d'un deuxième câbles supraconducteurs qui sont électriquement reliés entre eux au niveau d'une première zone de connexion et, au niveau d'une deuxième zone de connexion, le premier câble supraconducteur de chaque paire est électriquement relié à l'un des câbles supraconducteurs d'une autre paire, le deuxième câble supraconducteur de chaque paire étant relié à un terminal de connexion électrique ou à l'un des câbles supraconducteurs d'une autre paire, l'une des zones de connexion étant le centre de la bobine et l'autre des zones de connexion étant la périphérie de la bobine.

L'expression « zone de connexion » désigne, dans toute la description et les revendications, soit la périphérie de la bobine, soit le centre de la bobine. Les deux zones de connexion possibles sont la périphérie de la bobine et le centre de la bobine. Ainsi si l'une des zones de connexion est la périphérie de la bobine, l'autre des zones de connexion est le centre de la bobine. Inversement, si l'une des zones de connexion est le centre de la bobine, l'autre des zones de connexion est la périphérie de la bobine.

Ainsi, la différence de tension entre deux câbles adjacents peut être réduite.

L'invention peut également être améliorée en employant un isolant différent, dans son épaisseur ou ses caractéristiques, entre les différentes spires. En particulier, il est ainsi intéressant d'employer une épaisseur d'isolant plus ou moins importante, selon la différence de tension qui apparaitra entre deux câbles adjacents.

Le limiteur de courant est un dipôle, c'est à dire qu'il comporte précisément et uniquement deux terminaux de connexion. Ce dipôle limiteur de courant est destiné à être inséré dans un circuit électrique grâce à ses deux pôles et sa seule fonction est en relation avec le courant circulant entre ces deux pôles : dans certaines circonstances, le limiteur de courant limite le courant circulant entre ces deux pôles, et dans d'autres circonstances le limiteur de courant fait transiter le courant sans limitation entre les deux pôles. Dans tous ses modes de réalisation, le dipôle limiteur de courant comporte ainsi un premier terminal de connexion électrique et un deuxième terminal de connexion électrique. Le limiteur de courant comporte un conducteur de type supraconducteur qui s'étend selon un enroulement en spirale entre ces deux terminaux de connexion électrique. Autrement dit, le conducteur de type supraconducteur comporte deux extrémités, l'une de ces extrémités étant reliée au premier terminal de connexion électrique et l'autre de ces extrémités étant reliée au deuxième terminal de connexion électrique.

Entre les deux terminaux de connexion électrique, le conducteur de type supraconducteur est bobiné selon au moins deux allers-retours entre la périphérie et le centre de la bobine. Dans la présente description et les revendications, l'expression « le conducteur de type supraconducteur s'étend selon au moins deux allers-retours entre la périphérie et le centre de la bobine » désigne précisément le parcours du conducteur de type supraconducteur entre ses deux points extrêmes que sont les deux terminaux de connexion électrique. Un aller-retour (du conducteur de type supraconducteur entre la périphérie et le centre de la bobine) désigne précisément la caractéristique selon laquelle :
- le limiteur de courant formant une bobine, le conducteur de type supraconducteur est relié par l'une de ses extrémités au premier terminal de connexion électrique qui se trouve en périphérie de la bobine, respectivement au centre de cette bobine ;
- à partir du premier terminal de connexion, le conducteur de type supraconducteur s'étend en s'enroulant en direction du centre de la bobine, respectivement en direction de la périphérie de la bobine (cette première portion du conducteur de type supraconducteur étant désignée comme « l'aller ») ;
- à partir du centre de la bobine, respectivement de la périphérie de la bobine, le conducteur supraconducteur s'étend en s'enroulant en retour vers la périphérie de la bobine, respectivement vers le centre de la bobine (cette deuxième portion du conducteur de type supraconducteur étant désignée comme « le retour »).

Ainsi, par exemple, un conducteur de type supraconducteur qui s'étend selon deux allers-retours entre la périphérie et le centre de la bobine, et dont le premier terminal de connexion électrique est situé en périphérie de bobine, présentera le parcours suivant, depuis le premier terminal de connexion vers le deuxième terminal de connexion :
- depuis le premier terminal de connexion situé en périphérie de la bobine, le conducteur de type supraconducteur s'étend en s'enroulant vers le centre de la bobine ;
- à partir du centre de la bobine, le conducteur de type supraconducteur poursuit son enroulement selon un chemin inverse, vers la périphérie de la bobine ;
- à partir de la périphérie de la bobine, le conducteur de type supraconducteur s'étend en s'enroulant à nouveau vers le centre de la bobine ;
- à partir du centre de la bobine, le conducteur de type supraconducteur poursuit son enroulement selon un chemin inverse, vers la périphérie de la bobine.

De même, par exemple, un conducteur de type supraconducteur qui s'étend selon deux allers-retours entre la périphérie et le centre de la bobine, et dont le premier terminal de connexion électrique est situé au centre de la bobine, aura la disposition suivante :
- depuis le premier terminal de connexion situé au centre de la bobine, le conducteur de type supraconducteur s'étend en s'enroulant vers la périphérie de la bobine ;
- à partir de la périphérie de la bobine, le conducteur de type supraconducteur poursuit son enroulement selon un chemin inverse, vers le centre de la bobine ;
- depuis le centre de la bobine, le conducteur de type supraconducteur s'étend en s'enroulant à nouveau vers la périphérie de la bobine ;
- à partir de la périphérie de la bobine, le conducteur de type supraconducteur poursuit son enroulement selon un chemin inverse, vers le centre de la bobine.

Autrement dit, la caractéristique selon laquelle « le conducteur de type supraconducteur s'étend selon au moins deux allers-retours entre la périphérie et le centre de la bobine en reliant le premier terminal de connexion électrique au deuxième terminal de connexion électrique » signifie que le parcours du câble de type supraconducteur comporte au moins :
- une première portion s'étendant de la périphérie au centre de la bobine, respectivement du centre à la périphérie de la bobine ;
- une deuxième portion, distincte de la première portion, s'étendant du centre à la périphérie de la bobine, respectivement de la périphérie au centre de la bobine ;
- une troisième portion, distincte des première et deuxième portions, s'étendant de la périphérie au centre de la bobine, respectivement du centre à la périphérie de la bobine ;
- une quatrième portion, distincte des première. deuxième, et troisième portions, s'étendant du centre à la périphérie de la bobine, respectivement de la périphérie au centre de la bobine ;

Le parcours du câble de type supraconducteur est défini comme l'agencement de ce câble dans son trajet entre le premier terminal de connexion électrique et le deuxième terminal de connexion électrique.

Un bobinage avec plusieurs allers-retours permet en effet de réduire la tension entre deux câbles, et donc de limiter la dimension des isolants nécessaires. Le limiteur de courant selon l'invention permet une meilleure tenue en tension, ce qui autorise la réalisation d'un limiteur de courant plus compact et/ou admettant une tension de fonctionnement plus importante. La tenue en tension désigne la capacité du limiteur de courant à résister à une importante différence de potentiel, au vu des hautes tensions en jeu, au sein des éléments de sa structure, sans qu'une décharge électrique ne se produise entre ces éléments, autrement dit en garantissant que la tension de claquage de chaque élément du limiteur de courant, en particulier les espaceurs entre chaque câble, soit toujours supérieure à la tension maximale qui peut apparaitre aux bornes de cet élément lorsque le limiteur de courant devient résistif en réponse à un défaut du circuit.

En effet, l'enroulement bifilaire sous forme de spirale permet d'optimiser l'espace et de compacter le limiteur de courant mais génère par ailleurs intrinsèquement une difficulté liée au fait que, en cas de défaut, lorsque le conducteur devient résistif, une forte tension se développe à ses bornes et dans sa structure. La nécessité pour le conducteur de type supraconducteur d'être enroulé sous forme de bobine bifilaire accentue la difficulté car le conducteur doit donc parcourir le même trajet aussi bien dans un sens de rotation que dans le sens de rotation inverse, ce qui limite les possibilités de placement des composants du limiteur de courant et de circuit de passage du conducteur de type supraconducteur. Une différence de tension, proportionnelle à la longueur du conducteur, est donc présente entre deux câbles adjacents.

Un limiteur de courant selon l'invention permet de mettre en oeuvre une plus grande longueur de conducteur répartie en plusieurs tronçons de câble supraconducteur. La structure du limiteur de courant permet une meilleure tenue en tension, ce qui permet l'utilisation pour des tensions plus élevées qu'auparavant. En effet, l'agencement des câbles et des terminaux de connexion garantit une juxtaposition optimisée des éléments à tension élevée, tout en maintenant le tout dans une dimension plus compacte. Des objectifs a priori divergents (une meilleure tenue en tension et une meilleure compacité) sont ainsi atteints grâce à l'invention.

Le câble supraconducteur est un fil conducteur qui peut être d'une quelconque section, par exemple, ronde, ovale, ou rectangulaire. Il peut être constitué d'une âme recouverte d'un revêtement supraconducteur. Il peut avantageusement être constitué en partie d'un des matériaux suivants :
- REBa₂Cu₃O₇₊ₓ, ou RE représente un ou plusieurs éléments parmi Y et les terres rares (Gd, Nd, Dy, Eu, etc.) ;
- MgB₂ ;
- Bi₂Sr₂Ca₂Cu₃O₁₀₊ₓ ;
- Tout autre matériau supraconducteur et adapté à la fabrication de câbles limiteurs de courant.

En permettant au conducteur de type supraconducteur d'effectuer plusieurs allers-retours entre la périphérie et le centre de la bobine, des possibilités de répartition avantageuse des potentiels apparaissent. Ces possibilités peuvent ensuite être concrétisées par une distribution adéquate des éléments permettant de relier les câbles supraconducteurs entre eux.

L'épaisseur variable d'une couche d'isolant à l'autre participe au gain de compacité tout en maintenant la tenue en tension nécessaire.

Le limiteur de courant peut comporter les caractéristiques additionnelles suivantes, seules ou en combinaison :
- au moins un des câbles supraconducteurs est interposé entre les deux câbles supraconducteurs qui sont reliés chacun à un terminal de connexion ;
- les deux câbles supraconducteurs d'une même paire sont de même longueur ;
- entre les deux câbles supraconducteurs reliés aux terminaux de connexion, le nombre de couches d'isolant est égal au moins à la moitié du nombre total de câbles supraconducteurs ;
- les câbles supraconducteurs sont reliés entre eux au centre de la bobine, pour former lesdites paires, par des boucles de pontage ;
- lesdites boucles de pontage sont disposées côte à côte ;
- lesdites boucles de pontage sont réparties sur le contour interne de la bobine ;
- le conducteur de type supraconducteur est constitué de 2N câbles supraconducteurs agencés selon N paires, de N boucles de pontage au niveau d'une première zone de connexion de la bobine et de N-1 boucles de pontage au niveau d'une deuxième zone de connexion de la bobine, la première zone de connexion et la deuxième zone de connexion de la bobine étant choisies parmi la périphérie et le centre de la bobine, N étant supérieur ou égal à 2 ;
- le conducteur de type supraconducteur comporte N boucles de pontage au niveau de la périphérie de la bobine, respectivement au niveau du centre de la bobine, et de N-1 boucles de pontage au niveau du centre de la bobine, respectivement au niveau de la périphérie de la bobine ;
- le conducteur de type supraconducteur est constitué de 2N câbles supraconducteurs agencés selon N paires, de N boucles de pontage au centre de la bobine et de N-1 boucles de pontage à la périphérie de la bobine ;
- le conducteur de type supraconducteur est constitué de 2N câbles supraconducteurs agencés selon N paires, de N-1 boucles de pontage au centre de la bobine et de N boucles de pontage à la périphérie de la bobine ;
- le conducteur de type supraconducteur est constitué de quatre câbles supraconducteurs agencés selon deux paires, de deux boucles de pontage au centre de la bobine et d'une boucle de pontage à la périphérie de la bobine ;
- les deux boucles de pontage au centre de la bobine sont adjacentes, et la boucle de pontage à la périphérie de la bobine est située entre les deux terminaux de connexion ;
- au sein de la bobine, entre le câble supraconducteur relié à un terminal de connexion et le câble supraconducteur adjacent qui est relié à l'autre terminal de connexion, la couche d'isolant a une épaisseur plus importante que les autres couches d'isolant ;
- les deux boucles de pontage du centre de la bobine sont adjacentes, et la boucle de pontage de la périphérie de la bobine contourne un terminal de connexion ;
- les deux boucles de pontage au centre de la bobine sont concentriques, et la boucle de pontage à la périphérie de la bobine contourne un terminal de connexion ;
- le conducteur de type supraconducteur est constitué de six câbles supraconducteurs agencés selon trois paires, de trois boucles de pontage au centre de la bobine et de deux boucles de pontage à la périphérie de la bobine ;
- les trois boucles de pontage au centre de la bobine sont adjacentes et en ce que les deux boucles de pontage à la périphérie de la bobine contournent chacune un terminal de connexion ;
- deux des boucles de pontage du centre de la bobine sont concentriques et l'une des boucles de pontage de la périphérie de la bobine est disposée entre les deux terminaux de connexion ;
- l'une des boucles de pontage du centre de la bobine traverse diamétralement le centre de la bobine, les deux autres boucles de pontage du centre de la bobine étant situées de part et d'autre de cette dernière, et l'une des boucles de pontage de la périphérie de la bobine est disposée entre les deux terminaux de connexion ;
- le conducteur de type supraconducteur est constitué de huit câbles supraconducteurs agencés selon quatre paires, de quatre boucles de pontage au centre de la bobine et de trois boucles de pontage à la périphérie de la bobine ;
- les quatre boucles de pontage au centre de la bobine sont adjacentes et en ce que l'une des boucles de pontage de la périphérie de la bobine contourne un terminal de connexion et une autre des boucles de pontage, et la troisième boucle de pontage de la périphérie de la bobine est située entre les deux terminaux de connexion ;
- deux des boucles de pontage du centre de la bobine sont adjacentes, les deux autres boucles de pontage du centre de la bobine étant concentriques, et deux des boucles de pontage de la périphérie de la bobine sont situées entre les deux terminaux de connexion ;
- les quatre boucles de pontage du centre de la bobine sont adjacentes et les trois boucles de la périphérie de la bobine sont concentriques et entourent un terminal de connexion ;
- les câbles supraconducteurs forment un faisceau enroulé sur lui-même, l'une des couches d'isolant formant une couche d'isolant de faisceau disposée entre deux bobinages du faisceau, tandis que les autres couches d'isolant forment des couches d'isolant de câble disposées chacune entre deux câbles supraconducteurs, la couche d'isolant de faisceau étant située entre deux câbles supraconducteurs reliés chacun à un terminal de connexion ;
- le limiteur de courant comporte au moins deux couches d'isolant d'épaisseurs différentes ;
- le limiteur de courant comporte en outre au moins deux couches d'isolant constituées d'un matériau différent ;
- la couche d'isolant située entre deux câbles supraconducteurs dont la différence de potentiel est la plus faible, lorsque le dipôle limiteur de courant devient résistif, présente une épaisseur inférieure à celle des autres couches d'isolant ;
- la couche d'isolant située entre deux câbles supraconducteurs dont la différence de potentiel est la plus élevée, lorsque le dipôle limiteur de courant devient résistif, présente une épaisseur supérieure à celle des autres couches d'isolant ;
- la couche d'isolant de faisceau présente une épaisseur supérieure aux couches d'isolant de câble ;
- la couche d'isolant de faisceau présente une épaisseur supérieure à 2/3 de la somme des épaisseurs des couches d'isolant de câble ;
- la couche d'isolant de faisceau présente une épaisseur supérieure à 1,5 fois l'épaisseur d'une couche d'isolant de câble ;
- les câbles étant au nombre de 2n, la couche d'isolant de faisceau présente une épaisseur de l'ordre de n fois l'épaisseur d'une couche d'isolant de câble ;
- la première zone de connexion est située au centre de la bobine, et la deuxième zone de connexion est située en périphérie de la bobine ;
- la première zone de connexion est située en périphérie de la bobine, et la deuxième zone de connexion est située au centre de la bobine ;
- le limiteur de courant comporte quatre câbles supraconducteurs agencés selon deux paires, deux boucles de pontage au niveau d'une première zone de connexion, une boucle de pontage niveau d'une deuxième zone de connexion, et deux terminaux de connexion, la première zone de connexion et la deuxième zone de connexion de la bobine étant choisies parmi la périphérie et le centre de la bobine, la couche d'isolant de faisceau étant située entre deux câbles supraconducteurs reliés chacun à un terminal de connexion ;
- le limiteur de courant comporte six câbles supraconducteurs agencés selon trois paires, trois boucles de pontage au niveau d'une première zone de connexion, deux boucles de pontage au niveau d'une deuxième zone de connexion, et deux terminaux de connexion, la première zone de connexion et la deuxième zone de connexion de la bobine étant choisies parmi la périphérie et le centre de la bobine, la couche d'isolant de faisceau étant située entre deux câbles supraconducteurs reliés chacun à un terminal de connexion ;
- le limiteur de courant comporte huit câbles supraconducteurs agencés selon quatre paires, quatre boucles de pontage au niveau d'une première zone de connexion, trois boucles de pontage au niveau d'une deuxième zone de connexion, et deux terminaux de connexion, la première zone de connexion et la deuxième zone de connexion de la bobine étant choisies parmi la périphérie et le centre de la bobine, la couche d'isolant de faisceau étant située entre deux câbles supraconducteurs reliés chacun à un terminal de connexion.

Dans la description et les revendications, l'expression « boucle de pontage » est définie comme tout moyen de relier les extrémités de deux câbles supraconducteurs.

Un exemple préféré de réalisation de l'invention va maintenant être décrit en référence aux dessins annexés dans lesquels :
- la figure 1 représente schématiquement un limiteur de courant selon l'art antérieur ;
- la figure 2 est une vue schématique d'un limiteur de courant conforme à un premier mode de réalisation de l'invention ;
- la figure 2B est une vue schématique d'un limiteur de courant selon une variante du mode de réalisation de la figure 2.
- la figure 3 est une vue schématique d'un limiteur de courant conforme à un deuxième mode de réalisation de l'invention ;
- la figure 4 est une vue schématique d'un limiteur de courant conforme à un troisième mode de réalisation de l'invention ;
- la figure 5 est une vue schématique d'un limiteur de courant conforme à un quatrième mode de réalisation de l'invention ;
- la figure 6 est une vue schématique d'un limiteur de courant conforme à un cinquième mode de réalisation de l'invention ;
- la figure 7 est une vue schématique d'un limiteur de courant conforme à un sixième mode de réalisation de l'invention ;
- la figure 8 est une vue schématique d'un limiteur de courant conforme à un septième mode de réalisation de l'invention ;
- la figure 9 est une vue schématique d'un limiteur de courant conforme à un huitième mode de réalisation de l'invention ;
- la figure 10 est une vue schématique d'un limiteur de courant conforme à un neuvième mode de réalisation de l'invention ;
- la figure 11 est une vue schématique d'un limiteur de courant conforme à un dixième mode de réalisation de l'invention ;
- la figure 12 est une vue schématique d'un limiteur de courant conforme à un onzième mode de réalisation de l'invention.
- la figure 13 est une vue schématique d'un limiteur de courant conforme à un douzième mode de réalisation de l'invention ;
- la figure 14 est une vue schématique d'un limiteur de courant conforme à un treizième mode de réalisation de l'invention ;
- la figure 15 est une vue schématique d'un limiteur de courant selon une variante du mode de réalisation de la figure 14 ne faisant pas partie de l'invention.
- la figure 16 est une vue schématique d'un limiteur de courant conforme à un quinzième mode de réalisation de l'invention.

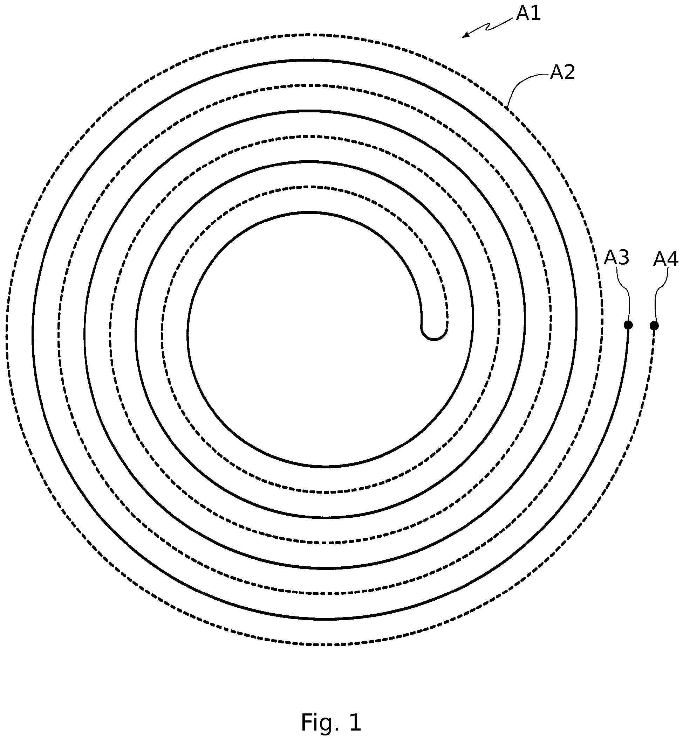

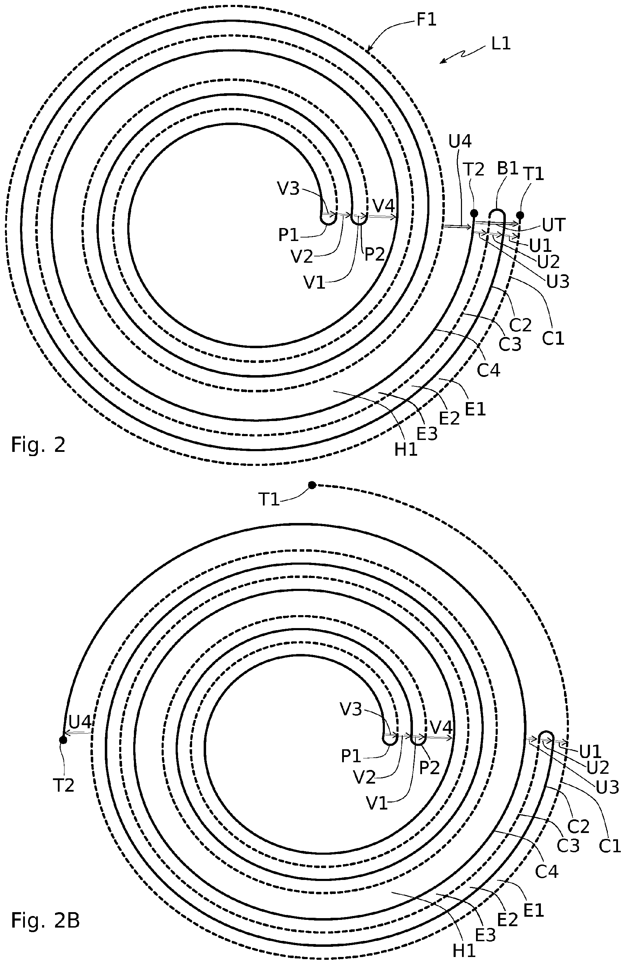

La figure 1 représente un limiteur de courant A1 selon l'art antérieur. Un tel limiteur de courant est constitué de l'enroulement d'un conducteur de type supraconducteur et de couches isolantes, sous forme de spirale. Le limiteur de courant A1 selon l'art antérieur comporte un unique conducteur A2 enroulé sous forme de bobine bifilaire, chaque extrémité du conducteur A2 étant relié à un terminal de connexion A3, A4. Les figures 2 à 16 montrent schématiquement la bobine résultant de ces enroulements, vue de dessus, de manière à montrer les structures d'enroulement et les connexions qui caractérisent l'invention. Le conducteur de type supraconducteur est enroulé de manière à former une bobine bifilaire s'étendant selon un plan unique (le plan des dessins). Les connexions électriques sont représentées de manière simplifiée, à la manière d'un schéma électrique, étant entendu que l'homme du métier saura réaliser ces connexions de manière pratique au vu notamment des contraintes mécaniques, d'encombrement et de coût. Dans les modes de réalisation des figures 2 à 12 :
- le limiteur de courant est un dipôle ;
- le limiteur de courant comporte un seul conducteur de type supraconducteur dont chaque extrémité est reliée à un terminal de connexion ;
- les deux terminaux de connexion forment les bornes du dipôle limiteur de courant ;
- le conducteur de type supraconducteur est constitué d'au moins deux paires de câbles supraconducteurs.

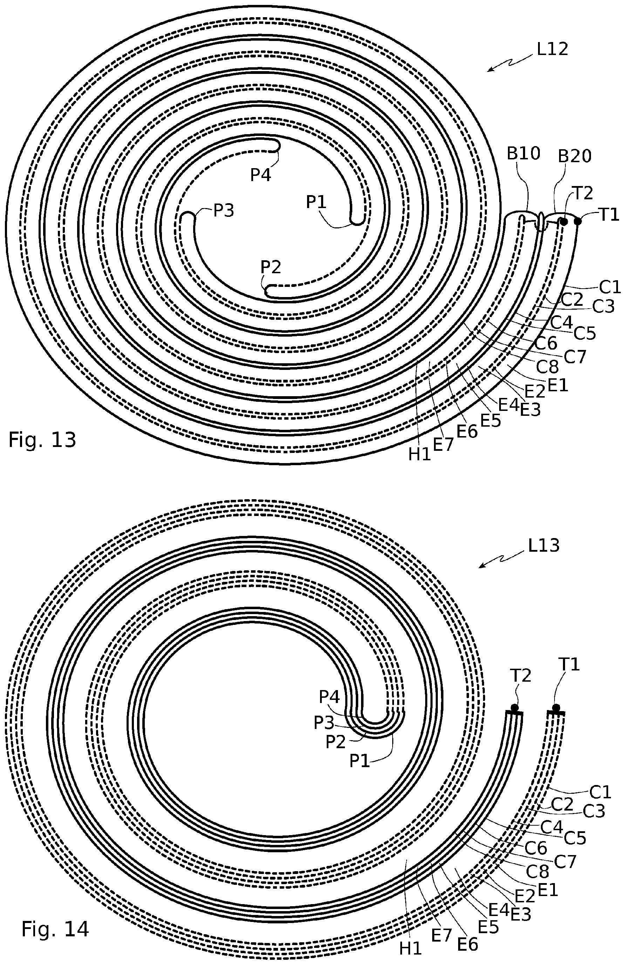

Dans les modes de réalisation des figures 13 à 16 :
- le limiteur de courant comporte un ou plusieurs conducteurs de type supraconducteur dont chaque extrémité est reliée à un terminal de connexion ;
- le conducteur de type supraconducteur est constitué d'au moins une paire de câbles supraconducteurs.

Pour faciliter la lecture, toutes les figures respectent la convention suivante :
- l'un des câbles supraconducteurs d'une paire est représenté en traits pleins tandis que l'autre des câbles supraconducteurs de cette même paire est représenté en traits pointillés, de manière à différencier clairement sur les figures le câble « aller » (le courant circule dans un sens, par exemple de la périphérie vers le centre) du câble « retour » (le courant circule dans l'autre sens, par exemple du centre vers la périphérie) d'une même paire de câbles supraconducteurs ;
- l'espace blanc entre les câbles supraconducteurs est constitué d'un isolant bobiné en parallèle avec le conducteur de sorte que toutes les spires de la bobine que constitue l'enroulement soient maintenues isolées les unes des autres par une couche de cet isolant. L'isolant est représenté schématiquement par l'espace blanc entre les câbles pour simplifier la figure. Il s'agit cependant d'un isolant, par exemple, en feuilles ou en bandes.

Toutes ces figures présentent les terminaux de connexion (bornes) du limiteur en périphérie de la bobine. Il est également possible d'employer des géométries quasi-identiques avec les terminaux de connexion au centre de la bobine. Ces schémas ne sont pas représentés mais sont des variantes possibles de l'invention.

Le limiteur de courant est refroidi, par exemple par un bain d'azote liquide, afin d'être maintenu aux températures nécessaires au maintien des propriétés supraconductrices du conducteur. L'isolant présent entre les spires du conducteur est donc de préférence poreux, ou muni de canaux, pour permettre le refroidissement par passage de fluide ou par bain.

La longueur du conducteur de type supraconducteur, et donc le nombre de spires de l'enroulement, est également simplifiée sur les dessins. A titre d'exemple, pour un limiteur de courant prévu pour 25 kV et dont le conducteur de type supraconducteur a une résistance linéique permettant une chute de tension de 50 V/m lorsqu'il devient résistif, ce conducteur devra avoir une longueur de l'ordre de 500 m, ce qui conduit à une bobine bifilaire de plusieurs mètres de diamètre et à un très grand nombre de tours.

Pour faciliter la description, une même convention est employée pour désigner les câbles et les tensions qui sont présentes entre ces câbles. Selon cette convention, si un limiteur de courant comporte X câbles :
- les câbles sont numérotés C1 à CX ;
- la tension présente, à la périphérie de l'enroulement, entre les câbles C1 et C2 est numérotée U1, celle présente entre les câbles C2 et C3 est numérotée U2,..., celle présente entre les câbles C(X-1) et CX est numérotée U(X-1) ;
- la tension présente, à la périphérie de l'enroulement, entre les câble CX et C1 (après un tour de l'enroulement) est numérotée UX ;
- la tension présente, au centre de l'enroulement, entre les câbles C1 et C2 est numérotée V1, celle présente entre les câbles C2 et C3 est numérotée V2,..., celle présente entre les câbles C(X-1) et CX est numérotée V(X-1) ;
- la tension présente, au centre de l'enroulement, entre les câble C1 et CX (après un tour de l'enroulement) est numérotée VX ;
- la couche isolante présente entre les câbles C1 et C2 est numérotée E1, celle présente entre les câbles C2 et C3 est numérotée E2,..., celle présente entre les câbles C(X-1) et CX est numérotée E(X-1) ;
- la couche isolante présente entre les câble CX et C1 est numérotée H1.

Les tensions sont représentées par des flèches sur les dessins mais seule la valeur absolue de ces tensions est considérée dans le présent texte.

La figure 2 est relative à un premier mode de réalisation de l'invention visant un limiteur de courant L1 qui comporte un conducteur de type supraconducteur F1. Le conducteur F1 est constitué de quatre câbles supraconducteurs C1, C2, C3, C4 enroulés parallèlement, sensiblement sous forme de spirale, avec quatre couches d'isolant E1, E2, E3, H1.

Au niveau de la périphérie de la spirale, le câble C1 est relié à un terminal de connexion T1 et le câble C4 est relié à un terminal de connexion T2. Les terminaux de connexion T1 et T2 sont les deux bornes par lesquelles le limiteur de courant L1 peut être relié à un circuit électrique pour y remplir sa fonction qui est de limiter le courant, dans ce circuit. Lorsque le limiteur de courant agit pour limiter le courant, le conducteur F1 devient fortement résistif et une tension apparait entre ces deux terminaux de connexion T1, T2. Cette tension est de niveau haute tension, dans la présente application.

Comme exposé précédemment, le limiteur de courant de tous les modes de réalisation est un dipôle dont la seule fonction est en relation avec le courant circulant, avec ou sans limitation, entre les deux terminaux de connexion T1 et T2.

Les deux terminaux de connexion T1, T2 sont placés dans la même zone de la périphérie de la spirale mais sont disposés de part et d'autre de l'épaisseur constituée des quatre câbles supraconducteurs C1, C2, C3, C4 et des trois couches d'isolant E1, E2, E3 prises entre eux. Sur la périphérie de la spirale, les câbles supraconducteurs C2 et C3, au centre de cette épaisseur, sont électriquement reliés entre eux par une boucle de pontage B1.

Le câble C4, raccordé au terminal de connexion T2, et le câble C3, raccordé à la boucle de pontage B1, sont de plus électriquement reliés ensemble au centre de la spirale, grâce à une boucle de pontage P1 et forment ainsi une première paire de câbles supraconducteurs. De même, le câble C1, raccordé au terminal de connexion T1, et le câble C2, raccordé à la boucle de pontage B1, sont de plus électriquement reliés ensemble au centre de la spirale, grâce à une boucle de pontage P2 et forment ainsi une deuxième paire de câbles supraconducteurs. Les boucles de pontage P1, P2 sont ici adjacentes et disposées côte à côte.

Le conducteur F1 parcourt ainsi, grâce aux deux paires C1, C2 et C3, C4 de câbles supraconducteurs, deux allers-retours entre la périphérie et le centre de la spirale.

Comme exposé précédemment dans la définition de la notion de « aller-retour », les deux allers-retours du conducteur F1 entre la périphérie et le centre de la bobine en forme de spirale sont ici constitués de :
- un premier « aller » réalisé par le câble C1 entre le terminal T1 et le centre de la bobine ;
- un premier « retour » réalisé par le câble C2 entre le centre de la bobine et la périphérie de la bobine ;
- un deuxième « aller » réalisé par le câble C3 entre la périphérie de la bobine et le centre de la bobine ;
- un deuxième « retour » réalisé par le câble C4 entre le centre de la bobine et le terminal T2 situé à la périphérie de la bobine.

Cette notion d'allers-retours d'un conducteur F réalisés par des câbles C fonctionne de la même manière pour tous les modes de réalisation décrits.

Les câbles supraconducteurs C1 à C4 forment un faisceau enroulé sur lui-même, l'une des couches d'isolant H1 formant une couche d'isolant de faisceau disposée entre deux bobinages du faisceau, tandis que les autres couches d'isolant E1 à E3 forment des couches d'isolant de câble disposées chacune entre deux câbles supraconducteurs.

Une tension se développe aux bornes du limiteur de courant L1 et dans sa structure, lorsqu'il devient résistif par perte des caractéristiques supraconductrices des câbles C1, C2, C3, C4 en réponse à une augmentation du courant due, par exemple à un défaut du circuit. La tension présente dans ce cas entre les terminaux de connexion T1, T2 est notée UT sur la figure 2. La distance entre les terminaux de connexion T1, T2 est fonction des épaisseurs des câbles supraconducteurs et des couches d'isolant.

De plus, chaque couche d'isolant doit assurer la tenue en tension de la tension qui apparait entre les deux câbles qu'elle sépare. La tension la plus élevée qui se développe au sein du limiteur de courant L1, entre deux câbles déterminés, conditionne donc l'épaisseur maximale nécessaire pour les couches d'isolant E1, E2, E3, H1. Ces épaisseurs de couche d'isolant sont ici optimisées conjointement au positionnement des câbles en vue d'un gain en épaisseur d'enroulement et/ou d'une meilleure tenue en tension de l'ensemble.

Chacune des épaisseurs d'isolant E1, E2, et E3 doit tenir respectivement une tension U1, U2, U3 en périphérie de la bobine et une tension V1, V2, V3 au centre de la bobine. Dans cet exemple, U1 est supérieure à V1 et U3 est supérieure à V3, tandis que V2 est supérieure à U2. Ces tension correspondant au maximum à UT / 2 dans la mesure où le conducteur F1 fait deux allers-retours entre la périphérie et le centre de la bobine en parcourant les quatre câbles C1, C2, C3, C4. En effet, la tension moyenne entre le câble C1 et le câble C2 sera de UT / 4, mais cette tension entre C1 et C2 sera en réalité variable et vaudra au minimum 0 (V1), et au maximum 2 x UT / 4 (U1).

En effet, si l'on considère que le terminal T2 est au potentiel UT, et que le limiteur de courant L1, lorsqu'il devient résistif, ramène le terminal T1 au potentiel zéro, alors chaque câble C1 à C4 procure une chute de tension de UT / 4. Dans ce cas :
- Le terminal T2 est donc au potentiel UT ;
- la boucle de pontage P1 est au potentiel 3.UT / 4 (soit UT - ¼ UT) car le câble C4 a été parcouru entre le terminal T2 et la boucle de pontage P1 ;
- la boucle de pontage B1 est au potentiel UT / 2 (soit UT - 2/4 UT) car le câble C4 et le câble C3 ont été parcourus entre le terminal T2 et la boucle de pontage B1 ;
- la boucle de pontage P2 est au potentiel UT / 4 (soit UT - ¾ UT) car le câble C4, le câble C3 et le câble C2 ont été parcourus entre le terminal T2 et la boucle de pontage P2 ;
- le terminal T1 est donc au potentiel zéro.

La tension maximale qui doit donc être tenue par la couche isolante H1 est donc la tension U4 qui apparait entre le terminal T2 (au potentiel UT) et le câble C1 (relié par un tour de spirale au terminal T1). Chacune des autres couches d'isolant E1 à E3 devra quant à elle tenir une tension maximale équivalent à 2 x UT / 4 = UT / 2.

La tension la plus importante qui se développe au sein du limiteur de courant L1, lorsqu'il est résistif, est donc la tension U4. Le câble C1 étant relié au terminal T1, la tension U4 est égale à la tension UT diminuée de la chute de tension provoquée par un tour de spirale du câble C1. La tension U4 est inférieure à UT de, par exemple, quelques dizaines ou centaines de volts (si l'on considère quelques mètres de câble C1 provoquant une chute de tension de 50 à 100 V/m). On peut la considérer comme quasi-égale à UT.

Pour la tenue en tension de U4, la couche d'isolant H1 qui est disposée entre le câble C4 et le câble C1 a une épaisseur supérieure à celle des couches d'isolant E1, E2 et E3, et/ou éventuellement un matériau différent ou une structure différente.

Dans le présent exemple, la couche d'isolant H1 a une épaisseur égale au double de l'épaisseur d'une couche d'isolant E1, E2, ou E3. Plus généralement, la couche d'isolant H1 a de préférence une épaisseur de l'ordre de N fois l'épaisseur d'une couche d'isolant E1, E2, ou E3, N étant le nombre d'allers-retours.

La figure 2B représente le même mode de réalisation de l'invention que la figure 2, avec un simple prolongement des câbles au niveau des terminaux T1 et T2, de sorte que les terminaux et les boucles de pontage ne soient pas alignés.

Cette variante ne change que très légèrement la distribution des potentiels. Elle est applicable pour tous les autres modes de réalisation qui seront détaillés par la suite.

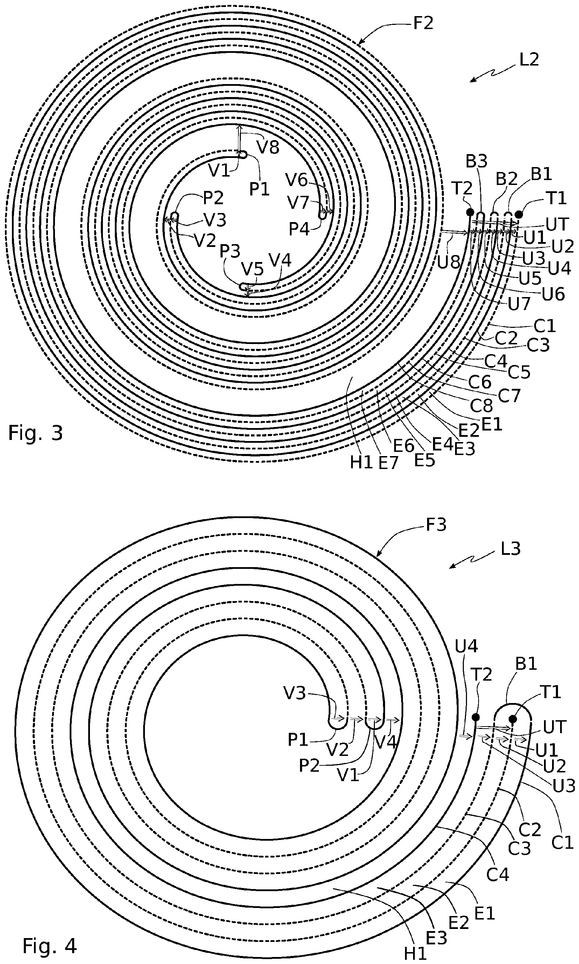

La figure 3 représente un deuxième mode de réalisation de l'invention où un limiteur de courant L2 comporte un conducteur de type supraconducteur F2 qui est ici constitué de huit câbles supraconducteurs C1 à C8 enroulés parallèlement, sensiblement sous forme de spirale, avec huit couches d'isolant E1 à E7 et H1.

Au niveau de la périphérie de la spirale, le câble C1 est relié à un terminal de connexion T1 et le câble C8 est relié à un terminal de connexion T2 pour la liaison du limiteur de courant L2 au circuit électrique à protéger.

Les deux terminaux de connexion T1, T2 sont placés dans la même zone de la périphérie de la spirale mais sont disposés de part et d'autre de l'épaisseur constituée des huit câbles supraconducteurs C1 à C8 et des sept couches d'isolant E1 à E7 prises entre eux. Entre les terminaux T1, T2, les câbles supraconducteurs C2 à C7, au centre de cette épaisseur, sont électriquement reliés entre eux, deux à deux, par des boucles de pontage. Les câbles C2 et C3 sont reliés par une boucle de pontage B1, les câbles C4 et C5 sont reliés par une boucle de pontage B2, et les câbles C6 et C7 sont reliés par une boucle de pontage B3.

Le câble C1, raccordé au terminal de connexion T1, et le câble C2, raccordé à la boucle de pontage B1, sont de plus électriquement reliés ensemble au centre de la spirale, grâce à une boucle de pontage P1 et forment ainsi une première paire de câbles supraconducteurs.

Le câble C3, raccordé à la boucle de pontage B1, et le câble C4, raccordé à la boucle de pontage B2, sont de plus électriquement reliés ensemble au centre de la spirale, grâce à une boucle de pontage P2 et forment ainsi une deuxième paire de câbles supraconducteurs.

Le câble C5, raccordé à la boucle de pontage B2, et le câble C6, raccordé à la boucle de pontage B3, sont de plus électriquement reliés ensemble au centre de la spirale, grâce à une boucle de pontage P3 et forment ainsi une troisième paire de câbles supraconducteurs.

Le câble C7, raccordé à la boucle de pontage B3, et le câble C8, raccordé au terminal de connexion T2, sont de plus électriquement reliés ensemble au centre de la spirale, grâce à une boucle de pontage P4 et forment ainsi une quatrième paire de câbles supraconducteurs.

Les boucles de pontage P1, P2, P3, P4 sont ici adjacentes mais ne sont pas disposées côte à côte, elles sont réparties régulièrement sur le contour interne de la bobine.

Le conducteur F2 parcourt ainsi, grâce aux quatre paires de câbles supraconducteurs C1 à C8, quatre allers-retours entre la périphérie et le centre de la spirale.

Au centre de la spirale, les boucles de pontage P1 à P4 sont angulairement réparties de manière régulière, en cercle, pour donner plus d'espace de montage à chacune. En variante, ces boucles de pontage P1 à P4 peuvent être disposées côte à côte comme celles du premier mode de réalisation ou répartie sur une portion du cercle central. Le montage en cercle peut simplifier la fabrication du limiteur de courant. Il suffit d'une pièce centrale sous forme de disque isolant avec quatre prises pour connecter les câbles.

Les câbles supraconducteurs C1 à C8 forment un faisceau enroulé sur lui-même, l'une des couches d'isolant H1 formant une couche d'isolant de faisceau disposée entre deux bobinages du faisceau, tandis que les autres couches d'isolant E1 à E7 forment des couches d'isolant de câble disposées chacune entre deux câbles supraconducteurs.

Dans ce deuxième mode de réalisation, la tension qui se développe aux bornes du limiteur de courant L2, lorsqu'il devient résistif, est également notée UT sur la figure 3.

Chacune des épaisseurs d'isolant E1 à E7 doit tenir une tension correspondant au maximum à UT / 4 dans la mesure où le conducteur F2 fait quatre allers-retours entre la périphérie et le centre de la bobine en parcourant les huit câbles C1 à C8.

En effet, si l'on considère que le terminal T2 est au potentiel UT, et que le limiteur de courant L2, lorsqu'il devient résistif, ramène le terminal T1 au potentiel zéro, alors chaque câble C1 à C8 procure une chute de tension de UT / 8. Dans ce cas :
- Le terminal T2 est donc au potentiel UT ;
- la boucle de pontage P4 est au potentiel 7.UT / 8 (soit UT - 1/8 UT) car seul le câble C8 a été parcouru entre le terminal T2 et la boucle de pontage P4 ;
- la boucle de pontage B3 est au potentiel 3.UT / 4 (soit UT - 2/8 UT) car le câble C8 et le câble C7 ont été parcourus entre le terminal T2 et la boucle de pontage B3 ;
- la boucle de pontage P3 est au potentiel 5.UT / 8 (soit UT - 3/8 UT) car le câble C8, le câble C7 et le câble C6 ont été parcourus entre le terminal T2 et la boucle de pontage P3 ;
- la boucle de pontage B2 est au potentiel UT / 2 (soit UT - 4/8 UT) car les câbles C8, C7, C6, et C5 ont été parcourus entre le terminal T2 et la boucle de pontage B2 ;
- la boucle de pontage P2 est au potentiel 3.UT / 8 (soit UT - 5/8 UT) car les câbles C8, C7, C6, C5, et C4 ont été parcourus entre le terminal T2 et la boucle de pontage P2 ;
- la boucle de pontage B1 est au potentiel UT / 4 (soit UT - 6/8 UT) car les câbles C8, C7, C6, C5, C4, et C3 ont été parcourus entre le terminal T2 et la boucle de pontage B1 ;
- la boucle de pontage P1 est au potentiel UT / 8 (soit UT - 7/8 UT) car les câbles C8, C7, C6, C5, C4, C3 et C2 ont été parcourus entre le terminal T2 et la boucle de pontage P1 ;
- le terminal T1 est donc au potentiel zéro.

La tension maximale qui doit être tenue par la couche isolante H1 est donc la tension U8 qui apparait entre le terminal T2 (au potentiel UT) et le câble C1 (relié par un tour de spirale au terminal T1). Chacune des autres couches d'isolant E1 à E7 doit quant à elle tenir une tension maximale équivalent à 2 x UT / 8 = UT / 4.

La tension la plus élevée qui se développe au sein du limiteur de courant L2 est donc la tension U8 qui est créée entre le terminal de connexion T2 et le câble C1 après que ce dernier ait fait un tour de spirale depuis le terminal T1. U8 est égale à la tension UT diminuée de la chute de tension provoquée par un tour de spirale du câble C1.

Pour la tenue en tension de U8, la couche d'isolant H1 qui est disposée entre le câble C8 et le câble C1 a une épaisseur supérieure à celle des couches d'isolant E1 à E7.

Dans le présent exemple, la couche d'isolant H1 a une épaisseur à peu près égale à 4 fois l'épaisseur d'une des couches d'isolant E1 à E7. Plus généralement dans ce mode de réalisation, la couche d'isolant H1 a de préférence une épaisseur de l'ordre de N fois l'épaisseur d'une couche d'isolant E1 à E7, N étant le nombre d'allers-retours.

La figure 4 est relative à un troisième mode de réalisation selon lequel le limiteur de courant L3 comporte un conducteur de type supraconducteur F3 constitué, comme dans le premier mode de réalisation, de quatre câbles supraconducteurs C1, C2, C3, C4 enroulés parallèlement, sensiblement sous forme de spirale, avec quatre couches d'isolant E1, E2, E3, H1.

Au niveau de la périphérie de la spirale, le câble C2 est relié à un terminal de connexion T1 et le câble C4 est relié à un terminal de connexion T2.

Les deux terminaux de connexion T1, T2 sont placés dans la même zone de la périphérie de la spirale mais sont disposés de part et d'autre du câble C3 et des deux couches d'isolant E2, E3 entourant ce dernier.

Selon ce troisième mode de réalisation :
- de part et d'autre du terminal T1, les câbles supraconducteurs C1 et C3 sont électriquement reliés par une boucle de pontage B1 ;
- Le câble C4, raccordé au terminal de connexion T2, et le câble C3, raccordé à la boucle de pontage B1, sont de plus électriquement reliés ensemble au centre de la spirale, grâce à une boucle de pontage P1 et forment ainsi une première paire de câbles supraconducteurs ;
- le câble C2, raccordé au terminal de connexion T1, et le câble C1, raccordé à la boucle de pontage B1, sont de plus électriquement reliés ensemble au centre de la spirale, grâce à une boucle de pontage P2 et forment ainsi une deuxième paire de câbles supraconducteurs.

Les boucles de pontage P1, P2 sont ici adjacentes et disposées côte à côte. Elles peuvent également être disposées en cercle, de manière similaire à la figure 3.

Le conducteur F3 parcourt ainsi, grâce aux deux paires C1, C2 et C3, C4 de câbles supraconducteurs, deux allers-retours entre la périphérie et le centre de la spirale. Cependant, le parcours suivi pour ces allers-retours est différent de celui du premier mode de réalisation en raison du positionnement différent des boucles de pontage P1, P2, B1.

Dans ce troisième mode de réalisation, la tension qui se développe aux bornes du limiteur de courant L3 quand il devient résistif est également notée UT sur la figure 4.

Chacune des épaisseurs d'isolant E1, E2, et E3 doit tenir respectivement une tension U1, U2, U3, en périphérie de la bobine et V1, V2, V3, au centre de la bobine. Parmi ces tensions, la tension maximale est de UT / 2.

La répartition des potentiels, avec chaque câble C1 à C4 procurant une chute de tension de UT / 4, est la suivante :
- Le terminal T2 est donc au potentiel UT ;
- la boucle de pontage P1 est au potentiel 3.UT / 4 (soit UT - ¼ UT) car le câble C4 a été parcouru entre le terminal T2 et la boucle de pontage P1 ;
- la boucle de pontage B1 est au potentiel UT / 2 (soit UT - 2/4 UT) car le câble C4 et le câble C3 ont été parcourus entre le terminal T2 et la boucle de pontage B1 ;
- la boucle de pontage P2 est au potentiel UT / 4 (soit UT - ¾ UT) car le câble C4, le câble C3 et le câble C1 ont été parcourus entre le terminal T2 et la boucle de pontage P2 ;
- le terminal T1 est donc au potentiel zéro.

U4 a une valeur de UT / 2 augmentée de la valeur de la chute de tension provoquée par un tour de spirale, tandis que parmi U1, U2, U3, V1, V2, V3, la valeur maximale est de UT / 2. La tension maximale qui doit donc être tenue par la couche isolante H1 est donc la tension U4. Chacune des autres couches d'isolant E1 à E3 doit tenir une tension égale à UT / 2, tandis que la couche H1 doit tenir une tension légèrement supérieure.

Dans le présent exemple, les couches d'isolant E1 à E3 et H1 sont d'égale épaisseur, étant toutes alignées sur l'épaisseur de H1.

En variante, la couche d'isolant H1 peut avoir, comme dans le premier mode de réalisation, une épaisseur différente de celles des couches d'isolant E1 à E3. Dans ce cas, elle aurait une épaisseur supérieure car la tension qu'elle doit tenir est supérieure de la valeur correspondant à la chute de tension liée à un tour de spirale, ce qui peut être une valeur importante dans le cas de spirales à grand diamètre et faible nombre de tours.

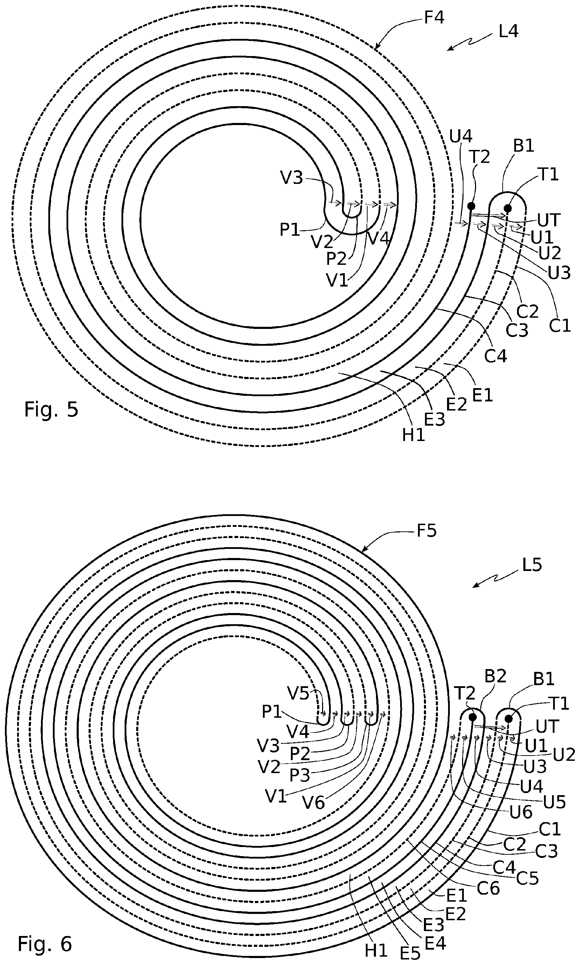

La figure 5 représente un quatrième mode de réalisation de l'invention, qui est une variante du troisième mode de réalisation. Cette variante vise un limiteur de courant L4 muni d'un câble de type supraconducteur F4, avec une disposition différente des bouches de pontage P1, P2.

Selon ce quatrième mode de réalisation :
- de part et d'autre du terminal T1, les câbles supraconducteurs C1 et C3 sont électriquement reliés par une boucle de pontage B1 ;
- Le câble C4, raccordé au terminal de connexion T2, et le câble C1, raccordé à la boucle de pontage B1, sont de plus électriquement reliés ensemble au centre de la spirale, grâce à une boucle de pontage P1 et forment ainsi une première paire de câbles supraconducteurs ;
- le câble C2, raccordé au terminal de connexion T1, et le câble C3, raccordé à la boucle de pontage B1, sont de plus électriquement reliés ensemble au centre de la spirale, grâce à une boucle de pontage P2 et forment ainsi une deuxième paire de câbles supraconducteurs.

A la différence du troisième mode de réalisation, les boucles de pontage P1, P2 ne sont pas adjacentes. Elles sont ici concentriques. Les boucles de pontage P1 et P2 ainsi concentriques donnent des possibilités différentes de connexion au centre de la spirale, par exemple par une seule et même pièce recourbée, à deux pistes parallèles.

De même que dans le troisième mode de réalisation, la répartition des tensions propres à ce quatrième mode de réalisation est la suivante :
- Le terminal T2 est donc au potentiel UT ;
- la boucle de pontage P1 est au potentiel 3.UT / 4 ;
- la boucle de pontage B1 est au potentiel UT / 2 ;
- la boucle de pontage P2 est au potentiel UT / 4 ;
- le terminal T1 est au potentiel zéro.

La tension maximale qui doit donc être tenue par l'une des couches isolantes E1, E2, E3, ou H1 est donc également la tension U4. Chacune des couches d'isolant E1 à E3 doit tenir au maximum une tension égale à UT / 2, tandis que la couche H1 doit tenir une tension supérieure. Cela permet également d'avoir des couches d'isolant E1 à E3 et H1 d'égale épaisseur, alignées sur celle de H1.

En variante, la couche d'isolant H1 peut également avoir, comme dans le premier mode de réalisation, une épaisseur différente de celles des couches d'isolant E1 à E3, notamment une épaisseur supérieure.

Les figures 6 à 8 visent des modes de réalisation dans lesquels le limiteur de courant comporte 6 câbles supraconducteurs répartis en trois paires.

La figure 6 représente un cinquième mode de réalisation de l'invention où un limiteur de courant L5 comporte un conducteur de type supraconducteur F5 qui est ici constitué de 6 câbles supraconducteurs C1 à C6 enroulés avec six couches d'isolant E1 à E5 etH1.

Les câbles C2 et C5 sont reliés respectivement, sur la périphérie de la spirale, aux terminaux de connexion T1 et T2.

Les deux terminaux de connexion T1, T2 sont ici disposés de part et d'autre des câbles C3 et C4 avec leurs trois couches d'isolant relatives E2, E3, E4.

Au niveau de la périphérie de la spirale, la boucle de pontage B1 relie le câble C1 et le câble C3, et la boucle de pontage B2 relie le câble C4 et le câble C6.

Au niveau du centre de la spirale :
- les câbles C5 et C6 sont reliés par une boucle de pontage P1, formant une première paire de câbles supraconducteurs ;
- les câbles C3 et C4 sont reliés par une boucle de pontage P2, formant une deuxième paire de câbles supraconducteurs ;
- les câbles C1 et C2 sont reliés par une boucle de pontage P3, formant une troisième paire de câbles supraconducteurs.

Les boucles de pontage P1, P2, P3 sont ici adjacentes et disposées côte à côte.

Le conducteur F5 parcourt ainsi, grâce aux trois paires de câbles supraconducteurs C1 à C6, trois allers-retours entre la périphérie et le centre de la spirale.

Selon ce cinquième mode de réalisation, si l'on considère que le terminal T2 est au potentiel UT, et que le limiteur de courant L5, lorsqu'il devient résistif, ramène le terminal T1 au potentiel zéro, alors chaque câble C1 à C6 procure une chute de tension de UT / 6. Dans ce cas :
- Le terminal T2 est donc au potentiel UT ;
- la boucle de pontage P1 est au potentiel 5.UT / 6 (soit UT - 1/6 UT) ;
- la boucle de pontage B2 est au potentiel 2.UT / 3 (soit UT - 2/6 UT) ;
- la boucle de pontage P2 est au potentiel UT / 2 (soit UT - 3/6 UT) ;
- la boucle de pontage B1 est au potentiel UT / 3 (soit UT - 4/6 UT) ;
- la boucle de pontage P3 est au potentiel UT / 6 (soit UT - 5/6 UT) ;
- le terminal T1 est donc au potentiel zéro.

A la différence des modes de réalisation précédents, le terminal T2 n'est pas adjacent au câble C1 vers le centre de l'enroulement. La tension U5 se développe entre le terminal T2 et le câble C6. La tension notée U6 sur la figure 6 est celle que apparait entre le câble C6 et le câble C1 au niveau de la zone située à un tour de spirale du terminal T1.

Parmi les tensions U1, U2, U3, U4, U5, V1, V2, V3, V4, V5 la valeur maximale est de UT / 3. La tension U6 a également une valeur maximale proche de UT / 3 (car elle apparait entre le câble C6 au potentiel 2.UT / 3 et le câble C1 au potentiel UT / 3 diminué de la chute de tension causée par un tour de spirale).

Dans ce cinquième mode de réalisation, la tension la plus élevée qui se développe au sein du limiteur de courant L5 est la tension V6 qui apparait au centre de la spirale, entre la boucle de pontage P3 et le câble C6. Cette tension est proche de 2.UT / 3. Le potentiel du câble C6 à cet endroit est en effet proche de 5.UT / 6 (car cet endroit est à un tour de spirale de la boucle de pontage P1), tandis que la boucle de pontage P3 est au potentiel UT / 6.

La couche d'isolant H1 est donc ici dimensionnée pour la tenue en tension de V6. Dans le présent exemple illustré, toutes les couches d'isolant sont de la même épaisseur. Les épaisseurs des couches E1 à E5 sont donc alignées sur celle de H1.

En variante, comme dans le premier et deuxième mode de réalisation, la couche d'isolant H1 peut être d'une épaisseur plus importante que les autres, elle sera alors dimensionnée pour la tenue d'une tension de 2.UT / 3 tandis que l'épaisseur des autres couches d'isolant E1 à E5 sera dans ce cas plus petite, dimensionnée pour la tenue d'une tension de UT / 3. Selon un exemple de cette variante, l'épaisseur de la couche d'isolant H1 peut valoir le double de l'épaisseur des autres couches d'isolant E1 à E5.

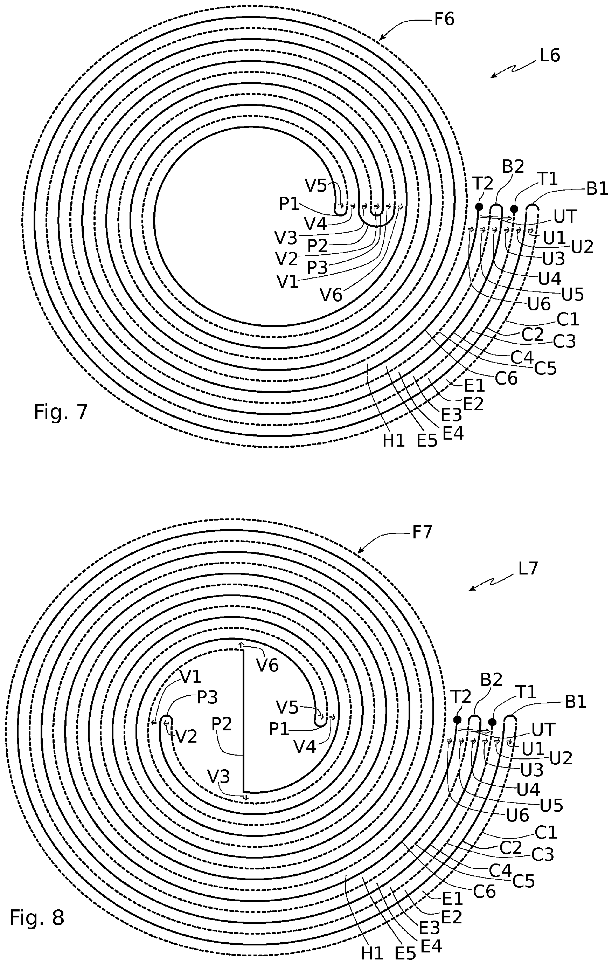

La figure 7 est relative à un sixième mode de réalisation qui est une variante du cinquième mode de réalisation. Cette variante vise une disposition différente des boucles de pontage P1, P2, P3, B1, B2 qui modifie le parcours du conducteur F6 et donc la répartition des tensions au sein du limiteur de courant L6.

Selon ce sixième mode de réalisation :
- les câbles C3 et C6 sont reliés respectivement, sur la périphérie de la spirale, aux terminaux de connexion T1 et T2 ;
- Les deux terminaux de connexion T1, T2 sont ici disposés de part et d'autre des câbles C4 et C5 avec leurs trois couches d'isolant relatives E3, E4, E5.

Au niveau de la périphérie de la spirale, la boucle de pontage B1 relie le câble C1 et le câble C2, et la boucle de pontage B2 relie le câble C4 et le câble C5.

Au niveau du centre de la spirale :
- les câbles C5 et C6 sont reliés par une boucle de pontage P1, formant la première paire de câbles supraconducteurs ;
- les câbles C1 et C4 sont reliés par une boucle de pontage P2, formant la deuxième paire de câbles supraconducteurs ;
- les câbles C2 et C3 sont reliés par une boucle de pontage P3, formant la troisième paire de câbles supraconducteurs.

Les boucles de pontage P2 et P3 sont concentriques et sont disposées côte à côte avec la boucle de pontage P1.

La répartition des potentiels est alors la suivante :
- Le terminal T2 est au potentiel UT ;
- la boucle de pontage P1 est au potentiel 5.UT / 6 (soit UT - 1/6 UT) ;
- la boucle de pontage B2 est au potentiel 2.UT / 3 (soit UT - 2/6 UT) ;
- la boucle de pontage P2 est au potentiel UT / 2 (soit UT - 3/6 UT) ;
- la boucle de pontage B1 est au potentiel UT / 3 (soit UT - 4/6 UT) ;
- la boucle de pontage P3 est au potentiel UT / 6 (soit UT - 5/6 UT) ;
- le terminal T1 est au potentiel zéro.

Selon ce sixième mode de réalisation, le terminal T2 est adjacent au câble C1.

La répartition des tensions notées sur la figure 7 est la suivante :
- parmi U5 et V5, la valeur maximale est de UT / 3 ;
- parmi U4 et V4, la valeur maximale est de UT / 3 ;
- parmi U3 et V3, la valeur maximale est de 2.UT / 3 ;
- parmi U2 et V2, la valeur maximale est de UT / 3 ;
- parmi U1 et V1, la valeur maximale est de UT / 3 ;
- U6 vaut un peu moins de 2.UT / 3 (il vaut 2.UT / 3 diminué de la chute de tension d'un tour de spirale).

Dans ce sixième mode de réalisation, la tension la plus élevée qui se développe au sein du limiteur de courant L6 est la tension U3 qui apparait entre la boucle de pontage B2 et le terminal T1, et qui vaut 2.UT / 3.

La couche d'isolant E3 est donc ici dimensionnée pour la tenue en tension de U3. Dans le présent exemple illustré, toutes les couches d'isolant sont de la même épaisseur. Les épaisseurs des couches E1, E2, E4, E5, H1 sont donc alignées sur celle de E3.

En variante, comme dans le premier et deuxième mode de réalisation, les couches d'isolant E3 et H1 peuvent être d'une épaisseur plus importante que les autres, elles seront alors dimensionnées pour la tenue d'une tension de 2.UT / 3 tandis que l'épaisseur des autres couches d'isolant E1, E2, E4, E5 sera dans ce cas plus petite.

La figure 8 est relative à un septième mode de réalisation qui est une variante du sixième mode de réalisation. Cette variante vise une disposition différente des boucles de pontage P1, P2, P3 au centre de la spirale. Le parcours du conducteur F7 n'est cependant pas modifié et donc la répartition des tensions au sein du limiteur de courant L7 est la même que pour le sixième mode de réalisation.

Selon ce septième mode de réalisation, les boucles de pontage P1 et P3 sont diamétralement opposées, tandis que la boucle de pontage P2 relie le câble C1 au câble C4 en traversant diamétralement le centre de la spirale, les deux autres boucles de pontage P1, P3 étant situées de part et d'autre de cette dernière.

La répartition des potentiels et des tensions étant la même que pour le sixième mode de réalisation, la tension la plus élevée qui se développe au sein du limiteur de courant L7 est donc la tension U3 qui apparait entre la boucle de pontage B2 et le terminal T1, et qui vaut 2.UT / 3.

Les couches d'isolant sont dimensionnées comme pour le sixième mode de réalisation, avec, en variante, des couches d'isolant d'épaisseurs différentes, notamment avec des épaisseurs E3 et H1 plus importantes que les autres.

La disposition des boucles de pontage P1, P2, P3 au centre de la spirale permet des possibilités supplémentaires de connexion.

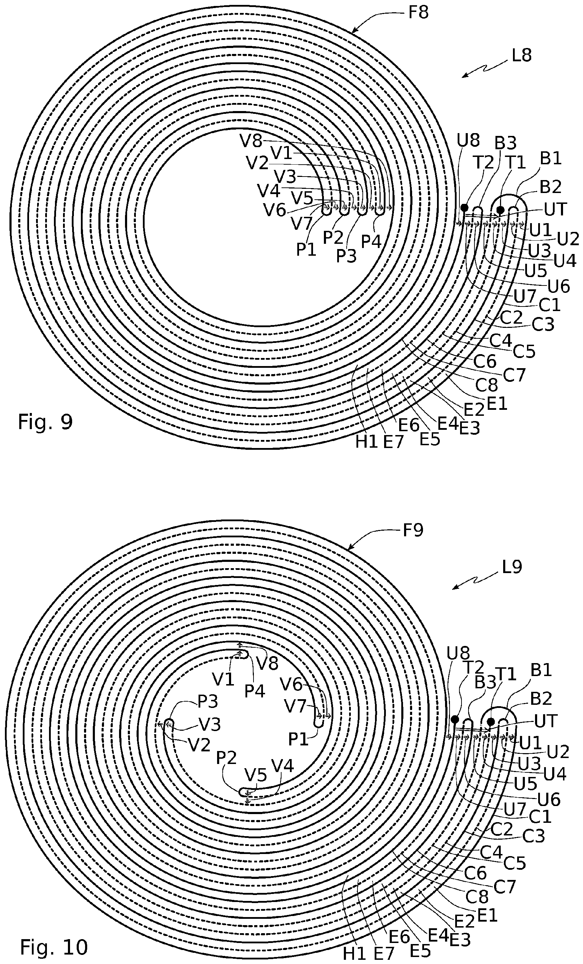

La figure 9 est relative à un huitième mode de réalisation où un limiteur de courant L8 comporte un conducteur de type supraconducteur F8 qui est ici constitué de 8 câbles supraconducteurs C1 à C8 enroulés avec huit couches d'isolant E1 à E7 et H1.

Selon ce huitième mode de réalisation :
- les câbles C4 et C8 sont reliés respectivement, sur la périphérie de la spirale, aux terminaux de connexion T1 et T2 ;
- Les deux terminaux de connexion T1, T2 sont ici disposés de part et d'autre des câbles C5 à C7 avec leur quatre couches d'isolant relatives E4 à E7 ;

Au niveau de la périphérie de la spirale, la boucle de pontage B1 relie le câble C1 et le câble C5, la boucle de pontage B2 relie le câble C2 et le câble C3 et la boucle de pontage B3 relie le câble C6 et le câble C7.

Au niveau du centre de la spirale :
- les câbles C7 et C8 sont reliés par une boucle de pontage P1, formant la première paire de câbles supraconducteurs ;
- les câbles C5 et C6 sont reliés par une boucle de pontage P2, formant la deuxième paire de câbles supraconducteurs ;
- les câbles C3 et C4 sont reliés par une boucle de pontage P3, formant la troisième paire de câbles supraconducteurs ;
- les câbles C1 et C2 sont reliés par une boucle de pontage P4, formant la quatrième paire de câbles supraconducteurs.

Les boucles de pontage P1, P2, P3 et P4 sont ici adjacentes et disposées côte à côte.

Considérant que chaque câble C1 à C8 procure une chute de tension de UT / 8, lors de l'apparition d'une tension UT aux bornes du limiteur de courant L8 devenu résistif :
- Le terminal T2 est donc au potentiel UT ;
- la boucle de pontage P1 est au potentiel 7.UT / 8 (soit UT - 1/8 UT) ;
- la boucle de pontage B3 est au potentiel 3.UT / 4 (soit UT - 2/8 UT) ;
- la boucle de pontage P2 est au potentiel 5.UT / 8 (soit UT - 3/8 UT) ;
- la boucle de pontage B1 est au potentiel UT / 2 (soit UT - 4/8 UT) ;
- la boucle de pontage P4 est au potentiel 3.UT / 8 (soit UT - 5/8 UT) ;
- la boucle de pontage B2 est au potentiel UT / 4 (soit UT - 6/8 UT) ;
- la boucle de pontage P3 est au potentiel UT / 8 (soit UT - 7/8 UT) ;
- le terminal T1 est donc au potentiel zéro.

Les tensions maximales qui doivent donc être tenues par l'une les couches isolantes E1 à E7, ou H1 sont donc :
- la tension U4 qui apparait entre le câble C5, au niveau de la boucle de pontage B1, et le terminal T1, et qui vaut au maximum UT / 2 ;
- la tension V4 qui apparait au centre de la spirale, entre les boucles de pontage P2 et P3, et qui vaut UT / 2 ;
- la tension U8 qui apparait en périphérie de la spirale, entre le terminal T2 et le câble C1, et qui vaut au maximum UT / 2 diminué de la chute de tension d'un tour de spirale en périphérie ;
- la tension V8 qui apparait au centre de la spirale, entre la boucle de pontage P4 et le câble C8, et qui vaut au maximum UT / 2 diminué de la chute de tension d'un tour de spirale au centre.

L'agencement des boucles de pontage P1 à P4, B1 à B3 permet de faire en sorte que seule la couche d'isolant E4 assure la tenue en tension des tensions U4 et V4. Cette dernière doit donc être dimensionnée pour la tenue en tension de UT / 2. Chacune des autres couches d'isolant E1 à E3, E5 à E7 doit quant à elle tenir une tension équivalent à UT / 4, sauf H1 qui peut être dimensionnée comme E4.

Dans le présent exemple illustré, toutes les couches d'isolant sont de la même épaisseur. Les épaisseurs des couches E1 à E3, E5 à E7 sont donc alignées sur celle de E4 et H1.

En variante, comme dans le premier et deuxième mode de réalisation, les couches d'isolant E4 et H1 peuvent être d'une épaisseur plus importante que les autres, par exemple du double de l'épaisseur.

La figure 10 est relative à un neuvième mode de réalisation qui est une variante du huitième mode de réalisation. Le limiteur de courant L9 comporte ici un conducteur de type supraconducteur F9 qui est ici constitué de 8 câbles supraconducteurs C1 à C7 enroulés avec huit couches d'isolant E1 à E7 et H1. Selon cette variante, les boucles de pontage P1, P2, P3, et P4 sont distribuées régulièrement sur le centre de la spirale. Les boucles de pontage P1 et P3 sont diamétralement opposées, de même que les boucles de pontage P2 et P4. Les boucles de pontage P1, P2, P3, P4 sont ici adjacentes mais ne sont pas disposées côte à côte, elles sont réparties régulièrement sur le contour interne de la bobine.

Les autres caractéristiques de ce neuvième mode de réalisation sont les mêmes que pour le huitième mode de réalisation.

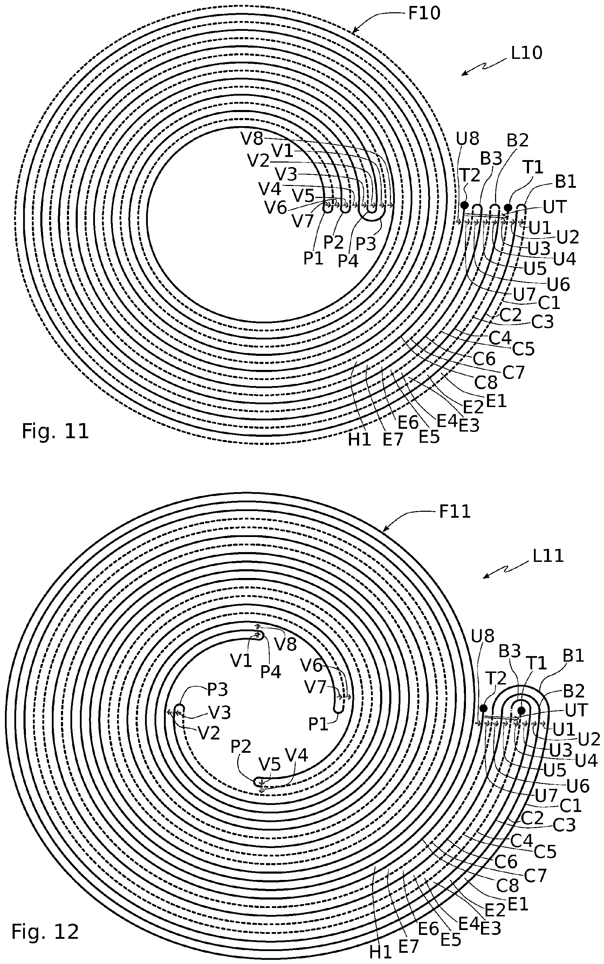

La figure 11 est relative à un dixième mode de réalisation où un limiteur de courant L10 comporte un conducteur de type supraconducteur F10 qui est ici constitué de 8 câbles supraconducteurs C1 à C8 enroulés avec huit couches d'isolant E1 à E7 et H1.

Selon ce dixième mode de réalisation :
- les câble C3 et C8 sont reliés respectivement, sur la périphérie de la spirale, aux terminaux de connexion T1 et T2 ;
- Les deux terminaux de connexion T1, T2 sont ici disposés de part et d'autre des câbles C4 à C7 avec leurs cinq couches d'isolant relatives E3 à E7.

Au niveau de la périphérie de la spirale, la boucle de pontage B1 relie le câble C1 et le câble C2, la boucle de pontage B2 relie le câble C4 et le câble C5, la boucle de pontage B3 relie le câble C6 et le câble C7.

Au niveau du centre de la spirale :
- les câbles C7 et C8 sont reliés par une boucle de pontage P1, formant la première paire de câbles supraconducteurs ;
- les câbles C5 et C6 sont reliés par une boucle de pontage P2, formant la deuxième paire de câbles supraconducteurs ;
- les câbles C4 et C1 sont reliés par une boucle de pontage P3, formant la troisième paire de câbles supraconducteurs ;
- les câbles C2 et C3 sont reliés par une boucle de pontage P4, formant la quatrième paire de câbles supraconducteurs.

Les boucles de pontage P1 et P2 sont ici adjacentes et disposées côte à côte, tandis que les boucles de pontage P3 et P4 sont concentriques.

La répartition des potentiels est alors la suivante :
- Le terminal T2 est donc au potentiel UT ;
- la boucle de pontage P1 est au potentiel 7.UT / 8 (soit UT - 1/8 UT) ;
- la boucle de pontage B3 est au potentiel 3.UT / 4 (soit UT - 2/8 UT) ;
- la boucle de pontage P2 est au potentiel 5.UT / 8 (soit UT - 3/8 UT) ;
- la boucle de pontage B2 est au potentiel UT / 2 (soit UT - 4/8 UT) ;
- la boucle de pontage P3 est au potentiel 3.UT / 8 (soit UT - 5/8 UT) ;
- la boucle de pontage B1 est au potentiel UT / 4 (soit UT - 6/8 UT) ;
- la boucle de pontage P4 est au potentiel UT / 8 (soit UT - 7/8 UT) ;
- le terminal T1 est donc au potentiel zéro.

Selon ce dixième mode de réalisation, le terminal T2 est adjacent au câble C1.

La répartition des tensions notées sur la figure 11 (en périphérie de la spirale) est donc la suivante :
- U7 vaut UT / 4 ;
- U6 vaut zéro ;
- U5 vaut UT / 4 ;
- U4 vaut zéro ;
- U3 vaut UT / 2 ;
- U2 vaut UT / 4 ;
- U1 vaut zéro ;
- U8 vaut un peu plus que 3.UT / 4 (U8 vaut 3.UT / 4 augmentée de la chute de tension d'un tour de spirale).

Au centre de la spirale, parmi les tensions V1 à V7, la valeur maximale est de UT / 4, et la tension V8 est proche de UT 12.

Dans ce dixième mode de réalisation, la tension la plus élevée qui se développe au sein du limiteur de courant L10 est la tension U8 qui apparait entre le terminal T2 et le câble C1 adjacent, et vaut un peu plus de 3.UT / 4.

La couche d'isolant H1 est donc ici dimensionnée pour la tenue en tension de U8. Dans le présent exemple illustré, toutes les couches d'isolant sont de la même épaisseur. Les épaisseurs des couches E1 à E7 sont donc alignées sur celle de H1.

En variante, comme dans le premier et deuxième mode de réalisation, la couche d'isolant H1 peut être d'une épaisseur plus importante que les autres, elle sera alors dimensionnée pour la tenue d'une tension supérieure à 3.UT / 4 tandis que l'épaisseur des autres couches d'isolant sera dans ce cas plus petite.

En variante, chaque couche d'isolant a une épaisseur propre qui est adaptée à la tension qu'elle doit tenir. Ainsi, selon cette variante :
- E7, E6, E5, E4, E2 et E1 ont une épaisseur dimensionnée pour la tenue en tension de UT / 4 car toutes ces couches d'isolant auront à tenir une tension de l'ordre de U/4, soit en périphérie, soit au centre de la bobine ;
- E3 a une épaisseur double de E7 ;
- H1 a la plus grande épaisseur, dimensionnée pour la tenue en tension d'un peu plus de 3.UT / 4.

La figure 12 représente un onzième mode de réalisation où un limiteur de courant L11 comporte un conducteur de type supraconducteur F11 qui est une variante du neuvième mode de réalisation. Les boucles de pontage P1, P2, P3, P4 au centre de la spirale sont identiques aux boucles de pontage correspondantes du neuvième mode de réalisation, de même que les câbles C4 et C8, reliés respectivement, sur la périphérie de la spirale, aux terminaux de connexion T1 et T2.

Selon cette variante, au niveau de la périphérie de la spirale, la boucle de pontage B1 relie le câble C1 et le câble C7, la boucle de pontage B2 relie le câble C2 et le câble C6, la boucle de pontage B3 relie le câble C3 et le câble C5. Les boucles de pontage B1, B2 et B3 sont concentriques.

La répartition des potentiels est alors la suivante :
- Le terminal T2 est au potentiel UT ;
- la boucle de pontage P1 est au potentiel 7.UT / 8 (soit UT - 1/8 UT) ;
- la boucle de pontage B1 est au potentiel 3.UT 14 (soit UT - 2/8 UT) ;
- la boucle de pontage P4 est au potentiel 5.UT / 8 (soit UT - 3/8 UT) ;
- la boucle de pontage B2 est au potentiel UT / 2 (soit UT - 4/8 UT) ;
- la boucle de pontage P2 est au potentiel 3.UT / 8 (soit UT - 5/8 UT) ;
- la boucle de pontage B3 est au potentiel UT / 4 (soit UT - 6/8 UT) ;
- la boucle de pontage P3 est au potentiel UT / 8 (soit UT - 7/8 UT) ;
- le terminal T1 est au potentiel zéro.

Selon ce onzième mode de réalisation, le terminal T2 est adjacent au câble C1.

La répartition des tensions notées sur la figure 12 est donc la suivante :
- U1 à U7 valent UT / 4 ;
- U8 vaut un peu moins que UT / 4 ;
- V2 et V6 valent UT / 2.
- V4 et V8 valent UT / 4.

Dans ce onzième mode de réalisation, les tensions les plus élevées qui se développent au sein du limiteur de courant L11 sont les tensions V2 et V6 qui apparaissent au centre de la spirale, respectivement entre la boucle de pontage P3 et le câble C2 adjacent, et entre la boucle de pontage P1 et le câble C6, et valent un peu plus de UT / 2.

Les couches d'isolant E2 et E6 sont donc ici dimensionnées pour la tenue des tensions V2 et V6. Dans le présent exemple illustré, toutes les couches d'isolant sont de la même épaisseur. Les épaisseurs des couches E1, E3, E4, E5, E7, H1 sont donc alignées sur celle de E2 et E6.

En variante, comme dans le premier et deuxième mode de réalisation, les couches d'isolant E2 et E6 peuvent être les seules à être d'une épaisseur plus importante que les autres, elles seront alors dimensionnée pour la tenue d'une tension légèrement supérieure à UT / 2 tandis que l'épaisseur des autres couches d'isolant sera dans ce cas plus petite.

La figure 13 illustre un douzième mode de réalisation selon lequel le limiteur de courant L12 comporte 8 câbles supraconducteurs. Les câbles C1, C4, C5, et C8 sont relié ensemble, au niveau de la périphérie de la bobine par trois boucles de pontage B10 qui sont également reliées au terminal de connexion T1. Les câbles C2, C3, C6, et C7 sont également reliés ensemble, au niveau de la périphérie de la bobine par trois boucles de pontage B20 qui sont également reliées au terminal de connexion T2.

Au niveau du centre de la bobine :
- les câbles C1 et C2 sont reliés par une boucle de pontage P4 ;
- les câbles C3 et C4 sont reliés par une boucle de pontage P3 ;
- les câbles C5 et C6 sont reliés par une boucle de pontage P2 ;
- les câbles C7 et C8 sont reliés par une boucle de pontage P1.

Les couches d'isolant E1, E3, E5, et E7 ont la même épaisseur dimensionnée pour la tenue en tension de la tension maximale apparaissant entre T1 et T2.

Les couches d'isolant E2, E4, E6, et H1 ont une même épaisseur qui est largement inférieure à l'épaisseur des couches d'isolant E1, E3, E5, et E7.

La figure 14 illustre un treizième mode de réalisation selon lequel le limiteur de courant L13 comporte 8 câbles supraconducteurs. Les câbles C1, C2, C3, et C4 sont relié ensemble, au niveau de la périphérie de la bobine, directement par le terminal de connexion T1. Les câbles C5, C6, C7, et C8 sont également reliés ensemble, au niveau de la périphérie de la bobine, directement par le terminal de connexion T2.

Au niveau du centre de la bobine :
- les câbles C1 et C8 sont reliés par une boucle de pontage P1 ;
- les câbles C2 et C7 sont reliés par une boucle de pontage P2 ;
- les câbles C3 et C6 sont reliés par une boucle de pontage P3 ;
- les câbles C4 et C5 sont reliés par une boucle de pontage P4.

Les couches d'isolant E4 et H1 ont la même épaisseur dimensionnée pour la tenue en tension de la tension maximale apparaissant entre T1 et T2.

Les couches d'isolant E1, E2, E3, E5, E6, et E7 ont une même épaisseur qui est largement inférieure à l'épaisseur des couches d'isolant E4 et H1.

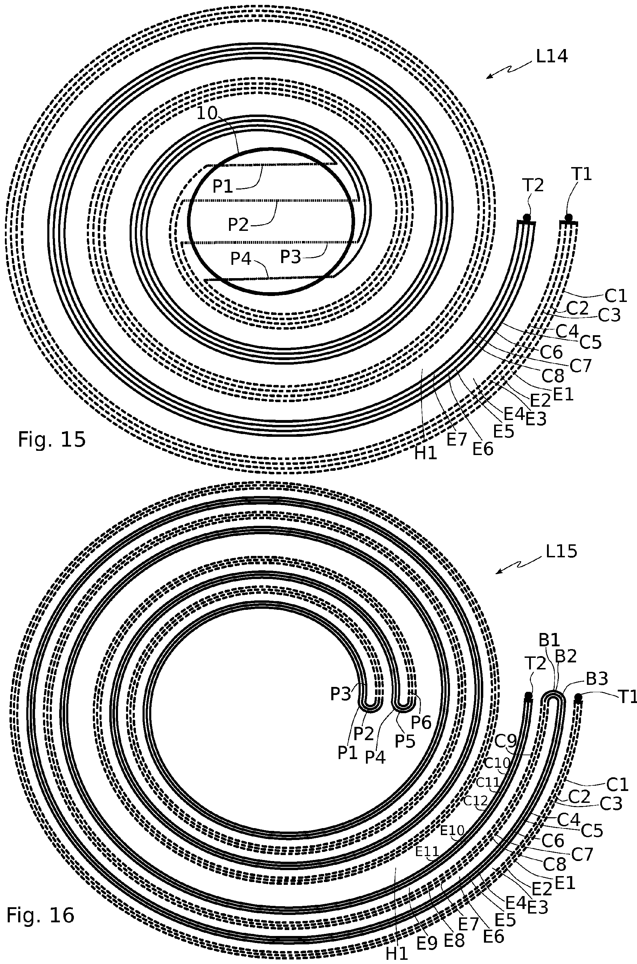

La figure 15 illustre une variante du mode de réalisation de la figure 14. Selon cette variante, le limiteur de courant L14 comporte en son centre un disque de liaison 10 portant les quatre boucles de liaison P1, P2, P3, P4.

Les liaisons au niveau du centre de la bobine sont les mêmes que pour la figure 14 :
- les câbles C1 et C8 sont reliés par la boucle de pontage P1 ;
- les câbles C2 et C7 sont reliés par la boucle de pontage P2 ;
- les câbles C3 et C6 sont reliés par la boucle de pontage P3 ;
- les câbles C4 et C5 sont reliés par la boucle de pontage P4.

Cependant, les boucles de liaison traversent le disque 10 qui les supporte et facilite le montage et les connexions au centre de la bobine. Les autres caractéristiques sont identiques à celles de la figure 14.

La figure 16 illustre un quinzième mode de réalisation selon lequel le limiteur de courant L15 comporte 12 câbles.

Au niveau de la périphérie :
- les câbles C1, C2 et C3 sont reliés au terminal T1.
- les câbles C10, C11 et C12 sont reliés au terminal T2.
- les câbles C4 et C9 sont reliés à la boucle de pontage B1
- les câbles C5 et C8 sont reliés à la boucle de pontage B2
- les câbles C6 et C7 sont reliés à la boucle de pontage B3.

Au niveau du centre de la bobine :
- les câbles C1 et C6 sont reliés à la boucle de pontage P4.
- les câbles C2 et C5 sont reliés à la boucle de pontage P5.
- les câbles C3 et C4 sont reliés à la boucle de pontage P6.
- les câbles C7 et C12 sont reliés à la boucle de pontage P1.
- les câbles C8 et C11 sont reliés à la boucle de pontage P2.
- les câbles C9 et C10 sont reliés à la boucle de pontage P3.

Les couches d'isolant E1, E2, E4, E5, E7, E8, E10 et E11 ont une même épaisseur qui peut être réduite au minimum.

Les couches d'isolant E3, E6, E9 et H1 peuvent être dimensionnées d'une manière similaire au cas de la figure 2.

En conclusion, dans tous les modes de réalisation décrits ci-dessus, on joue sur la disposition des boucles de pontage et/ou des épaisseurs de couches isolantes pour augmenter la tenue en tension et/ou rendre plus compact le limiteur de courant.

D'autres variantes de réalisation du limiteur de courant peuvent être mises en oeuvre sans sortir du cadre de l'invention. Par exemple, chaque conducteur de type supraconducteur peut être formé d'un conducteur unique, ou peut être formé de plusieurs câbles supraconducteurs mis en parallèle entre eux (ce qui conduit à une simple augmentation de la section du conducteur). Les boucles de pontage quant à elles peuvent être réalisées de différentes manières : conducteur replié sur lui-même, pièce munie d'un bornier de connexion et de pistes conductrices intermédiaires, dispositifs mécaniques de fixation, ou autre. La résistance électrique des boucles de pontage est de préférence faible, par exemple, du niveau de celle du cuivre.

Par ailleurs, le limiteur de courant peut avoir un nombre quelconque de tours de spirale, bien au-delà du faible nombre de tours des exemples schématiques décrits ici en vue d'expliquer le principe. L'expression « enroulements en spirale » doit de plus être comprise au sens large, c'est à dire que le conducteur de type supraconducteur est enroulé en couches par rotations successives, la section pouvant être, par exemple, carrée ou d'une quelconque autre forme.

Sur la vue schématique des figures 4, 5, 6, 9, 10, 12, et 13 une ou des boucles de pontage entourent un terminal de connexion, étant entendu que l'homme du métier saura réaliser de telles connexions sur le dispositif réel, par exemple en faisant transiter le terminal en question par un plan perpendiculaire au plan du dessin, en vue de le dégager des boucles de pontage et de réaliser les connexions de bornes.

Dans les exemples décrits, le centre de la bobine forme une première zone de connexion munie de boucles de pontage et la périphérie de la bobine forme une deuxième zone de connexion munie de boucles de pontage, de sorte que deux câbles supraconducteurs sont électriquement reliés entre eux au niveau de la première zone de connexion et, au niveau de la deuxième zone de connexion, l'un des câbles supraconducteurs d'une paire est électriquement relié à l'un des câbles supraconducteurs d'une autre paire, l'autre câble supraconducteur de chaque paire étant relié à un terminal de connexion électrique ou à une paire supplémentaire. Cependant, en variante, la première zone de connexion peut être située en périphérie de la bobine, et la deuxième zone de connexion peut être située au centre de la bobine, les boucles de pontage étant alors inversées, et les terminaux de connexion se retrouvent alors au centre de la bobine.

Par ailleurs, dans tous les schémas à l'exception de la figure 2B, pour des raisons de simplicité, on a présenté les terminaux de connexion T1 et T2 côte à côte. Cependant, les terminaux de connexion peuvent également être décalés angulairement (par exemple d'un quart de tour), si leur raccordement à un circuit est ainsi facilité.

## Revendications

1. Dipôle limiteur de courant (L1 à L15) à supraconducteur, dont les deux bornes sont constituées par un premier terminal de connexion électrique (T1) et un deuxième terminal de connexion électrique (T2), ce dipôle limiteur de courant comportant un conducteur de type supraconducteur (F1 à F15) enroulé pour former une bobine bifilaire s'étendant selon un plan unique, une couche d'isolant (E1 à E11, H1) étant disposée entre deux spires de ladite bobine, ledit conducteur de type supraconducteur (F1 à F15) étant constitué d'au moins quatre câbles supraconducteurs (C1 à C12) distincts enroulés parallèlement et agencés selon au moins deux paires, chacune des paires étant formée de deux desdits câbles supraconducteurs (C1 à C12), les câbles supraconducteurs (C1 à C12) étant reliés entre eux de sorte que le conducteur de type supraconducteur s'étende selon au moins deux allers-retours entre la périphérie et le centre de la bobine en reliant le premier terminal de connexion électrique (T1) au deuxième terminal de connexion électrique (T2).

2. Dipôle limiteur de courant selon la revendication 1, **caractérisé en ce que** chacune des paires est formée d'un premier et d'un deuxième câbles supraconducteurs (C1 à C12) qui sont électriquement reliés entre eux au niveau d'une première zone de connexion, et **en ce que**, au niveau d'une deuxième zone de connexion, le premier câble supraconducteur de chaque paire est électriquement relié à l'un des câbles supraconducteurs d'une autre paire, le deuxième câble supraconducteur de chaque paire étant relié à l'un des terminaux de connexion électriques (T1, T2) ou à l'un des câbles supraconducteurs d'une autre paire, l'une des zones de connexion étant le centre de la bobine et l'autre des zones de connexion étant la périphérie de la bobine.

3. Dipôle limiteur de courant l'une des revendications 1 ou 2, **caractérisé en ce qu'**au moins un des câbles supraconducteurs est interposé entre les deux câbles supraconducteurs qui sont reliés chacun à l'un des terminaux de connexion électrique (T1, T2).

4. Dipôle limiteur de courant selon l'une des revendications précédentes, **caractérisé en ce que** les deux câbles supraconducteurs d'une même paire sont de même longueur.

5. Dipôle limiteur de courant selon l'une des revendications précédentes, **caractérisé en ce que**, entre les deux câbles supraconducteurs reliés aux terminaux de connexion (T1, T2), le nombre de couches d'isolant est supérieur ou égal à la moitié du nombre total de câbles supraconducteurs.

6. Dipôle limiteur de courant selon l'une des revendications précédentes, **caractérisé en ce que** les câbles supraconducteurs (C1 à C12) sont reliés entre eux au centre de la bobine, pour former lesdites paires, par des boucles de pontage (P1 à P6).

7. Dipôle limiteur de courant selon la revendication 6, **caractérisé en ce que** lesdites boucles de pontage (P1 à P6) sont disposées côte à côte.

8. Dipôle limiteur de courant selon la revendication 6, **caractérisé en ce que** lesdites boucles de pontage (P1 à P6) sont réparties sur le contour interne de la bobine.

9. Dipôle limiteur de courant selon l'une des revendications précédentes, **caractérisé en ce que** le conducteur de type supraconducteur est constitué de 2N câbles supraconducteurs agencés selon N paires, de N boucles de pontage au niveau d'une première zone de connexion de la bobine et de N-1 boucles de pontage au niveau d'une deuxième zone de connexion de la bobine, la première zone de connexion et la deuxième zone de connexion de la bobine étant choisies parmi la périphérie et le centre de la bobine, N étant supérieur ou égal à 2.

10. Dipôle limiteur de courant selon la revendication 9, **caractérisé en ce que** le conducteur de type supraconducteur comporte N boucles de pontage au niveau de la périphérie de la bobine, respectivement au niveau du centre de la bobine, et de N-1 boucles de pontage au niveau du centre de la bobine, respectivement au niveau de la périphérie de la bobine.

11. Dipôle limiteur de courant selon l'une des revendications 9 ou 10, **caractérisé en ce que** le conducteur de type supraconducteur (F1 à F15) est constitué de 2N câbles supraconducteurs (C1 à C12) agencés selon N paires, de N boucles de pontage (P1, à P6) au centre de la bobine et de N-1 boucles de pontage (B1 à B3) à la périphérie de la bobine.

12. Dipôle limiteur de courant selon l'une des revendications 9 ou 10, **caractérisé en ce que** le conducteur de type supraconducteur est constitué de 2N câbles supraconducteurs agencés selon N paires, de N-1 boucles de pontage au centre de la bobine et de N boucles de pontage à la périphérie de la bobine.

13. Dipôle limiteur de courant selon la revendication 11, **caractérisé en ce que** le conducteur de type supraconducteur (F1, F3, F4) est constitué de quatre câbles supraconducteurs (C1 à C4) agencés selon deux paires, de deux boucles de pontage (P1, P2) au centre de la bobine et d'une boucle de pontage (B1) à la périphérie de la bobine.

14. Dipôle limiteur de courant selon la revendication 13, **caractérisé en ce que** les deux boucles de pontage (P1, P2) au centre de la bobine sont adjacentes, et **en ce que** la boucle de pontage (B1) à la périphérie de la bobine est située entre les deux terminaux de connexion (T1, T2).

15. Dipôle limiteur de courant selon la revendication 14, **caractérisé en ce que**, au sein de la bobine, entre le câble supraconducteur (C4) relié à un terminal de connexion (T2) et le câble supraconducteur adjacent (C1) qui est relié à l'autre terminal de connexion (T1), la couche d'isolant (H1) a une épaisseur plus importante que les autres couches d'isolant (E1 à E3).

16. Dipôle limiteur de courant selon la revendication 13, **caractérisé en ce que** les deux boucles de pontage (P1, P2) du centre de la bobine sont adjacentes, et **en ce que** la boucle de pontage (B1) de la périphérie de la bobine contourne un terminal de connexion (T1).

17. Dipôle limiteur de courant selon la revendication 13, **caractérisé en ce que** les deux boucles de pontage (P1, P2) au centre de la bobine sont concentriques, et **en ce que** la boucle de pontage (B1) à la périphérie de la bobine contourne un terminal de connexion (T1).

18. Dipôle limiteur de courant selon la revendication 11, **caractérisé en ce que** le conducteur de type supraconducteur (F5, F6, F7) est constitué de six câbles supraconducteurs (C1 à C6) agencés selon trois paires, de trois boucles de pontage (P1, P2, P3) au centre de la bobine et de deux boucles de pontage (B1, B2) à la périphérie de la bobine.

19. Dipôle limiteur de courant selon la revendication 18, **caractérisé en ce que** les trois boucles de pontage (P1, P2, P3) au centre de la bobine sont adjacentes et **en ce que** les deux boucles de pontage (B1, B2) à la périphérie de la bobine contournent chacune un terminal de connexion (T1, T2).

20. Dipôle limiteur de courant selon la revendication 18, **caractérisé en ce que** deux des boucles de pontage (P2, P3) du centre de la bobine sont concentriques et **en ce que** l'une des boucles de pontage (B2) de la périphérie de la bobine est disposée entre les deux terminaux de connexion (T1, T2).

21. Dipôle limiteur de courant selon la revendication 18, **caractérisé en ce que** l'une des boucles de pontage (P2) du centre de la bobine traverse diamétralement le centre de la bobine, les deux autres boucles de pontage (P1, P3) du centre de la bobine étant situées de part et d'autre de cette dernière, et **en ce que** l'une des boucles de pontage (B2) de la périphérie de la bobine est disposée entre les deux terminaux de connexion (T1, T2).

22. Dipôle limiteur de courant selon la revendication 11, **caractérisé en ce que** le conducteur de type supraconducteur (L3 ; L8 à L11) est constitué de huit câbles supraconducteurs (C1 à C8) agencés selon quatre paires, de quatre boucles de pontage (P1 à P4) au centre de la bobine et de trois boucles de pontage (B1 à B3) à la périphérie de la bobine.

23. Dipôle limiteur de courant selon la revendication 22, **caractérisé en ce que** les quatre boucles de pontage (P1 à P4) au centre de la bobine sont adjacentes et **en ce que** l'une des boucles de pontage (B1) de la périphérie de la bobine contourne un terminal de connexion (T1) et une autre des boucles de pontage (B2), et **en ce que** la troisième boucle de pontage (B3) de la périphérie de la bobine est située entre les deux terminaux de connexion (T1, T2).

24. Dipôle limiteur de courant selon la revendication 22, **caractérisé en ce que** deux des boucles de pontage (P1, P2) du centre de la bobine sont adjacentes, les deux autres boucles de pontage (P3, P4) du centre de la bobine étant concentriques, et **en ce que** deux des boucles de pontage (B2, B3) de la périphérie de la bobine sont situées entre les deux terminaux de connexion (T1, T2).

25. Dipôle limiteur de courant selon la revendication 22, **caractérisé en ce que** les quatre boucles de pontage (P1 à P4) du centre de la bobine sont adjacentes et **en ce que** les trois boucles (B1 à B3) de la périphérie de la bobine sont concentriques et entourent un terminal de connexion (T1, T2).

26. Dipôle limiteur de courant selon l'une des revendications précédentes, **caractérisé en ce que** :
- les câbles supraconducteurs (C1 à C12) forment un faisceau enroulé sur lui-même, l'une des couches d'isolant (H1) formant une couche d'isolant de faisceau disposée entre deux bobinages du faisceau, tandis que les autres couches d'isolant (E1 à E11) forment des couches d'isolant de câble disposées chacune entre deux câbles supraconducteurs, la couche d'isolant de faisceau (H1) étant située entre deux câbles supraconducteurs reliés chacun à un terminal de connexion (T1, T2) ;
- le limiteur de courant comporte au moins deux couches d'isolant d'épaisseurs différentes.

27. Dipôle limiteur de courant selon la revendication 26, **caractérisé en ce qu'**il comporte en outre au moins deux couches d'isolant constituées d'un matériau différent.

28. Dipôle limiteur de courant selon l'une des revendications précédentes, **caractérisé en ce que** la couche d'isolant située entre deux câbles supraconducteurs dont la différence de potentiel est la plus faible, lorsque le dipôle limiteur de courant devient résistif, présente une épaisseur inférieure à celle des autres couches d'isolant.

29. Dipôle limiteur de courant selon l'une des revendications précédentes, **caractérisé en ce que** la couche d'isolant située entre deux câbles supraconducteurs dont la différence de potentiel est la plus élevée, lorsque le dipôle limiteur de courant devient résistif, présente une épaisseur supérieure à celle des autres couches d'isolant.

30. Dipôle limiteur de courant selon l'une des revendications précédentes, **caractérisé en ce que** la couche d'isolant de faisceau (H1) présente une épaisseur supérieure aux couches d'isolant de câble (E1 à E11).

31. Dipôle limiteur de courant selon l'une des revendications précédentes, **caractérisé en ce que** la couche d'isolant de faisceau (H1) présente une épaisseur supérieure à 2/3 de la somme des épaisseurs des couches d'isolant de câble (E1 à E11).

32. Dipôle limiteur de courant selon l'une des revendications 26 à 30, **caractérisé en ce que** la couche d'isolant de faisceau (H1) présente une épaisseur supérieure à 1,5 fois l'épaisseur d'une couche d'isolant de câble (E1 à E11).

33. Dipôle limiteur de courant selon la revendication 30, **caractérisé en ce que**, les câbles étant au nombre de 2n, la couche d'isolant de faisceau (H1) présente une épaisseur de l'ordre de n fois l'épaisseur d'une couche d'isolant de câble (E1 à E11).

34. Dipôle limiteur de courant selon l'une des revendications 2 à 33, **caractérisé en ce que** la première zone de connexion est située au centre de la bobine, et **en ce que** la deuxième zone de connexion est située en périphérie de la bobine.

35. Dipôle limiteur de courant selon l'une des revendications 2 à 33, **caractérisé en ce que** la première zone de connexion est située en périphérie de la bobine, et **en ce que** la deuxième zone de connexion est située au centre de la bobine.

36. Dipôle limiteur de courant selon l'une des revendications 34 ou 35, **caractérisé en ce qu'**il comporte quatre câbles supraconducteurs (C1 à C4) agencés selon deux paires, deux boucles de pontage (P1, P2) au niveau d'une première zone de connexion, une boucle de pontage (B1) au niveau d'une deuxième zone de connexion, et deux terminaux de connexion (T1, T2), la première zone de connexion et la deuxième zone de connexion de la bobine étant choisies parmi la périphérie et le centre de la bobine, la couche d'isolant de faisceau (H1) étant située entre deux câbles supraconducteurs reliés chacun à un terminal de connexion (T1, T2).

37. Dipôle limiteur de courant selon l'une des revendications 34 ou 35, **caractérisé en ce qu'**il comporte six câbles supraconducteurs (C1 à C6) agencés selon trois paires, trois boucles de pontage (P1 à P3) au niveau d'une première zone de connexion, deux boucles de pontage (B1, B2) au niveau d'une deuxième zone de connexion, et deux terminaux de connexion (T1, T2), la première zone de connexion et la deuxième zone de connexion de la bobine étant choisies parmi la périphérie et le centre de la bobine, la couche d'isolant de faisceau (H1) étant située entre deux câbles supraconducteurs reliés chacun à un terminal de connexion (T1, T2).

38. Dipôle limiteur de courant selon l'une des revendications 34 ou 35, **caractérisé en ce qu'**il comporte huit câbles supraconducteurs (C1 à C8) agencés selon quatre paires, quatre boucles de pontage (P1 à P4) au niveau d'une première zone de connexion, trois boucles de pontage (B1 à B3) au niveau d'une deuxième zone de connexion, et deux terminaux de connexion (T1, T2), la première zone de connexion et la deuxième zone de connexion de la bobine étant choisies parmi la périphérie et le centre de la bobine, la couche d'isolant de faisceau (H1) étant située entre deux câbles supraconducteurs reliés chacun à un terminal de connexion (T1, T2).

## Patentansprüche

1. Supraleitender Strombegrenzungsdipol (L1 bis L15), dessen beide Verbinder durch eine erste elektrische Anschlussklemme (T1) und eine zweite elektrische Anschlussklemme (T2) gebildet werden, wobei dieser Strombegrenzungsdipol einen Leiter vom Supraleitertyp (F1 bis F15) aufweist, der gewickelt ist, um eine zweiadrige Spule zu bilden, die sich gemäß einer einzigen Ebene erstreckt, wobei eine Isolierschicht (E1 bis E11, H1) zwischen beiden Windungen der Spule angeordnet ist, der Leiter vom Supraleitertyp (F1 bis F15) aus mindestens vier verschiedenen supraleitenden Kabeln (C1 bis C12) gebildet wird, die parallel gewickelt und gemäß mindestens zwei Paaren angeordnet sind, wobei jedes der Paare aus zwei der supraleitenden Kabel (C1 bis C12) gebildet wird, wobei die supraleitenden Kabel (C1 bis C12) so miteinander verbunden sind, dass der Leiter vom Supraleitertyp sich gemäß mindestens zwei Hin- und Rückläufen zwischen dem Rand und der Mitte der Spule erstreckt, indem er die erste elektrische Anschlussklemme (T1) mit der zweiten elektrischen Anschlussklemme (T2) verbindet.

2. Strombegrenzungsdipol nach Anspruch 1, **dadurch gekennzeichnet, dass** jedes der Paare aus einem ersten und einem zweiten supraleitenden Kabel (C1 bis C12) gebildet wird, die auf der Ebene eines ersten Anschlussbereichs elektrisch miteinander verbunden sind, und dass auf der Ebene eines zweiten Anschlussbereichs das erste supraleitende Kabel jedes Paares elektrisch mit einem der supraleitenden Kabel eines anderen Paares verbunden ist, wobei das zweite supraleitende Kabel jedes Paares mit einer der elektrischen Anschlussklemmen (T1, T2) oder mit einem der supraleitenden Kabel eines anderen Paares verbunden ist, wobei einer der Anschlussbereiche die Spulenmitte und der andere der Anschlussbereiche der Spulenrand ist.

3. Strombegrenzungsdipol nach einem der Ansprüche 1 oder 2, **dadurch gekennzeichnet, dass** mindestens eines der supraleitenden Kabel zwischen den beiden supraleitenden Kabeln angeordnet ist, die jeweils mit einer der elektrischen Anschlussklemmen (T1, T2) verbunden sind.

4. Strombegrenzungsdipol nach einem der vorhergehenden Ansprüche, **dadurch gekennzeichnet, dass** die beiden supraleitenden Kabel eines Paars von gleicher Länge sind.

5. Strombegrenzungsdipol nach einem der vorhergehenden Ansprüche, **dadurch gekennzeichnet, dass** zwischen den beiden mit den Anschlussklemmen (T1, T2) verbundenen supraleitenden Kabeln die Anzahl der Isolierschichten größer oder gleich der Hälfte der Gesamtzahl der supraleitenden Kabel ist.

6. Strombegrenzungsdipol nach einem der vorhergehenden Ansprüche, **dadurch gekennzeichnet, dass** die supraleitenden Kabel (C1 bis C12) der Spulenmitte durch Überbrückungsschleifen (P1 bis P6) miteinander verbunden sind, um die genannten Paare zu bilden.

7. Strombegrenzungsdipol nach Anspruch 6, **dadurch gekennzeichnet, dass** die Überbrückungsschleifen (P1 bis P6) nebeneinander angeordnet sind.

8. Strombegrenzungsdipol nach Anspruch 6, **dadurch gekennzeichnet, dass** die Überbrückungsschleifen (P1 bis P6) über die Innenkontur der Spule verteilt sind.

9. Strombegrenzungsdipol nach einem der vorhergehenden Ansprüche, **dadurch gekennzeichnet, dass** der Leiter vom Supraleitertyp aus 2N supraleitenden Kabeln, die gemäß N Paaren angeordnet sind, aus N Überbrückungsschleifen auf der Ebene eines ersten Anschlussbereichs der Spule und aus N - 1 Überbrückungsschleifen auf der Ebene eines zweiten Anschlussbereichs der Spule gebildet wird, wobei der erste Anschlussbereich und der zweite Anschlussbereich der Spule aus dem Rand und der Mitte der Spule ausgewählt sind, wobei N größer oder gleich 2 ist.

10. Strombegrenzungsdipol nach Anspruch 9, **dadurch gekennzeichnet, dass** der Leiter vom Supraleitertyp auf der Ebene des Spulenrands bzw. auf der Ebene der Spulenmitte N Überbrückungsschleifen und auf der Ebene der Spulenmitte bzw. auf der Ebene des Spulenrands N - 1 Überbrückungsschleifen aufweist.

11. Strombegrenzungsdipol nach einem der Ansprüche 9 oder 10, **dadurch gekennzeichnet, dass** der Leiter vom Supraleitertyp (F1 bis F15) aus 2N supraleitenden Kabeln (C1 bis C12), die gemäß N Paaren angeordnet sind, aus N Überbrückungsschleifen (P1 bis P6) der Spulenmitte und aus N - 1 Überbrückungsschleifen (B1 bis B3) am Spulenrand gebildet wird.

12. Strombegrenzungsdipol nach einem der Ansprüche 9 oder 10, **dadurch gekennzeichnet, dass** der Leiter vom Supraleitertyp aus 2N supraleitenden Kabeln, die gemäß N Paaren angeordnet sind, aus N - 1 Überbrückungsschleifen der Spulenmitte und aus N Überbrückungsschleifen am Spulenrand gebildet wird.

13. Strombegrenzungsdipol nach Anspruch 11, **dadurch gekennzeichnet, dass** der Leiter vom Supraleitertyp (F1, F3, F4) aus vier supraleitenden Kabeln (C1 bis C4), die gemäß zwei Paaren angeordnet sind, aus zwei Überbrückungsschleifen (P1, P2) der Spulenmitte und aus einer Überbrückungsschleife (B1) am Spulenrand gebildet wird.

14. Strombegrenzungsdipol nach Anspruch 13, **dadurch gekennzeichnet, dass** die beiden Überbrückungsschleifen (P1, P2) der Spulenmitte benachbart sind, und dass die Überbrückungsschleife (B1) am Spulenrand zwischen den beiden Anschlussklemmen (T1, T2) liegt.

15. Strombegrenzungsdipol nach Anspruch 14, **dadurch gekennzeichnet, dass** im Inneren der Spule zwischen dem supraleitenden Kabel (C4), das mit einem Anschluss (T2) verbunden ist, und dem benachbarten supraleitenden Kabel (C1), das mit dem anderen Anschluss (T1) verbunden ist, die Isolierschicht (H1) eine viel größere Dicke als die anderen Isolierschichten (E1 bis E3) hat.

16. Strombegrenzungsdipol nach Anspruch 13, **dadurch gekennzeichnet, dass** die beiden Überbrückungsschleifen (P1, P2) der Spulenmitte benachbart sind und dass die Überbrückungsschleife (B1) des Spulenrands eine Anschlussklemme (T1) umgeht.

17. Strombegrenzungsdipol nach Anspruch 13, **dadurch gekennzeichnet, dass** die beiden Überbrückungsschleifen (P1, P2) der Spulenmitte konzentrisch sind, und dass die Überbrückungsschleife (B1) am Spulenrand eine Anschlussklemme (I1) umgeht.

18. Strombegrenzungsdipol nach Anspruch 11, **dadurch gekennzeichnet, dass** der Leiter vom Supraleitertyp (F5, F6, F7) aus sechs supraleitenden Kabeln (C1 bis C6), die gemäß drei Paaren angeordnet sind, aus drei Überbrückungsschleifen (P1, P2, P3) der Spulenmitte und aus zwei Überbrückungsschleifen (B1, B2) am Spulenrand gebildet wird.

19. Strombegrenzungsdipol nach Anspruch 18, **dadurch gekennzeichnet, dass** die drei Überbrückungsschleifen (P1, P2, P3) der Spulenmitte benachbart sind und dass die beiden Überbrückungsschleifen (B1, B2) am Spulenrand jeweils eine Anschlussklemme (T1, T2) umgehen.

20. Strombegrenzungsdipol nach Anspruch 18, **dadurch gekennzeichnet, dass** zwei der Überbrückungsschleifen (P2, P3) der Spulenmitte konzentrisch sind und dass eine der Überbrückungsschleifen (B2) am Spulenrand zwischen den beiden Anschlussklemmen (T1, T2) angeordnet ist.

21. Strombegrenzungsdipol nach Anspruch 18, **dadurch gekennzeichnet, dass** eine der Überbrückungsschleifen (P2) der Spulenmitte diametral die Spulenmitte überquert, wobei die beiden anderen Überbrückungsschleifen (P1, P3) der Spulenmitte auf beiden Seiten der Spule liegen, und dass eine der Überbrückungsschleifen (B2) des Spulenrands zwischen den beiden Anschlussklemmen (T1, T2) liegt.

22. Strombegrenzungsdipol nach Anspruch 11, **dadurch gekennzeichnet, dass** der Leiter vom Supraleitertyp (L3; L8 bis L11) aus acht supraleitenden Kabeln (C1 bis C8), die gemäß vier Paaren angeordnet sind, vier Überbrückungsschleifen (P1 bis P4) der Spulenmitte und drei Überbrückungsschleifen (B1 bis B3) am Spulenrand gebildet wird.

23. Strombegrenzungsdipol nach Anspruch 22, **dadurch gekennzeichnet, dass** die vier Überbrückungsschleifen (P1 bis P4) der Spulenmitte benachbart sind und dass eine der Überbrückungsschleifen (B1) am Spulenrand eine Anschlussklemme (I1) und eine andere der Überbrückungsschleifen (B2) umgeht, und dass die dritte Überbrückungsschleife (B3) am Spulenrand zwischen den beiden Anschlussklemmen (T1, T2) liegt.

24. Strombegrenzungsdipol nach Anspruch 22, **dadurch gekennzeichnet, dass** zwei der Überbrückungsschleifen (P1, P2) der Spulenmitte benachbart sind, wobei die zwei anderen Überbrückungsschleifen (P3, P4) der Spulenmitte konzentrisch sind, und dass zwei der Überbrückungsschleifen (B2, B3) des Spulenrands zwischen den beiden Anschlussklemmen (T1, T2) liegen.

25. Strombegrenzungsdipol nach Anspruch 22, **dadurch gekennzeichnet, dass** die vier Überbrückungsschleifen (P1 bis P4) der Spulenmitte benachbart sind und dass die drei Schleifen (B1 bis B3) des Spulenrands konzentrisch sind und eine Anschlussklemme (T1, T2) umschließen.

26. Strombegrenzungsdipol nach einem der vorhergehenden Ansprüche, **dadurch gekennzeichnet, dass**:
- die supraleitenden Kabel (C1 bis C12) ein um sich selbst gewickeltes Bündel bilden, wobei eine der Isolierschichten (H1) eine Bündelisolierschicht bildet, die zwischen zwei Wicklungen des Bündels angeordnet ist, während die anderen Isolierschichten (E1 bis E11) Kabelisolierschichten bilden, die jeweils zwischen zwei supraleitenden Kabeln angeordnet sind, wobei die Bündelisolierschicht (H1) zwischen zwei supraleitenden Kabeln liegt, die jeweils mit einer Anschlussklemme (T1, T2) verbunden sind;
- der Strombegrenzer mindestens zwei Isolierschichten mit unterschiedlichen Dicken aufweist.

27. Strombegrenzungsdipol nach Anspruch 26, **dadurch gekennzeichnet, dass** er zusätzlich mindestens zwei Isolierschichten aufweist, die aus einem unterschiedlichem Material gebildet werden.

28. Strombegrenzungsdipol nach einem der vorhergehenden Ansprüche, **dadurch gekennzeichnet, dass** die Isolierschicht, die zwischen zwei supraleitenden Kabeln mit der geringsten Potentialdifferenz liegt, wenn der Strombegrenzungsdipol resistiv wird, eine geringere Dicke als die anderen Isolierschichten darstellt.

29. Strombegrenzungsdipol nach einem der vorhergehenden Ansprüche, **dadurch gekennzeichnet, dass** die Isolierschicht, die zwischen zwei supraleitenden Kabeln mit der höchsten Potentialdifferenz liegt, wenn der Strombegrenzungsdipol resistiv wird, eine größere Dicke als die anderen Isolierschichten darstellt.

30. Strombegrenzungsdipol nach einem der vorhergehenden Ansprüche, **dadurch gekennzeichnet, dass** die Bündelisolierschicht (H1) eine größere Dicke als die Kabelisolierschichten (E1 bis E11) darstellt.

31. Strombegrenzungsdipol nach einem der vorhergehenden Ansprüche, **dadurch gekennzeichnet, dass** die Bündelisolierschicht (H1) eine Dicke darstellt, die größer als 2/3 der Summe der Dicken der Kabelisolierschichten (E1 bis E11) ist.

32. Strombegrenzungsdipol nach einem der Ansprüche 26 bis 30, **dadurch gekennzeichnet, dass** die Bündelisolierschicht (H1) eine Dicke darstellt, die größer als das 1,5-fache der Dicke einer Kabelisolierschicht (E1 bis E11) ist.

33. Strombegrenzungsdipol nach Anspruch 30, **dadurch gekennzeichnet, dass** bei einer Anzahl von 2n Kabeln die Bündelisolierschicht (H1) eine Dicke in der Größenordnung des n-fachen der Dicke einer Kabelisolierschicht (E1 bis E11) darstellt.

34. Strombegrenzungsdipol nach einem der Ansprüche 2 bis 33, **dadurch gekennzeichnet, dass** der erste Anschlussbereich in der Spulenmitte liegt und dass der zweite Anschlussbereich am Spulenrand liegt.

35. Strombegrenzungsdipol nach einem der Ansprüche 2 bis 33, **dadurch gekennzeichnet, dass** der erste Anschlussbereich am Spulenrand liegt und dass der zweite Anschlussbereich in der Spulenmitte liegt.

36. Strombegrenzungsdipol nach einem der Ansprüche 34 oder 35, **dadurch gekennzeichnet, dass** er vier supraleitende Kabel (C1 bis C4), die gemäß zwei Paaren angeordnet sind, zwei Überbrückungsschleifen (P1, P2) auf der Ebene eines ersten Anschlussbereichs, eine Überbrückungsschleife (B1) auf der Ebene eines zweiten Anschlussbereichs und zwei Anschlussklemmen (T1, T2) aufweist, wobei der erste Anschlussbereich und der zweite Anschlussbereich der Spule aus dem Rand und der Mitte der Spule ausgewählt werden, wobei die Bündelisolierschicht (H1) zwischen zwei supraleitenden Kabeln liegt, die jeweils mit einer Anschlussklemme (T1, T2) verbunden sind.

37. Strombegrenzungsdipol nach einem der Ansprüche 34 oder 35, **dadurch gekennzeichnet, dass** er sechs supraleitende Kabel (C1 bis C6), die gemäß drei Paaren angeordnet sind, drei Überbrückungsschleifen (P1 bis P3) auf der Ebene eines ersten Anschlussbereichs, zwei Überbrückungsschleifen (B1, B2) auf der Ebene eines zweiten Anschlussbereichs, und zwei Anschlussklemmen (T1, T2) aufweist, wobei der erste Anschlussbereich und der zweite Anschlussbereich der Spule aus dem Rand und der Mitte der Spule ausgewählt werden, wobei die Bündelisolierschicht (H1) zwischen zwei supraleitenden Kabeln liegt, die jeweils mit einer Anschlussklemme (T1, T2) verbunden sind.

38. Strombegrenzungsdipol nach einem der Ansprüche 34 oder 35, **dadurch gekennzeichnet, dass** er acht supraleitende Kabel (C1 bis C8), die gemäß vier Paaren angeordnet sind, vier Überbrückungsschleifen (P1 bis P4) auf der Ebene eines ersten Anschlussbereichs, drei Überbrückungsschleifen (B1 bis B3) auf der Ebene eines zweiten Anschlussbereichs und zwei Anschlussklemmen (T1, T2) aufweist, wobei der erste Anschlussbereich und der zweite Anschlussbereich der Spule aus dem Rand und der Mitte der Spule ausgewählt werden, wobei die Bündelisolierschicht (H1) zwischen zwei supraleitenden Kabeln liegt, die jeweils mit einer Anschlussklemme (T1, T2) verbunden sind.

## Claims

1. A superconducting current limiting dipole (L1 to L15), the two terminals of which are formed by a first electrical connection terminal (T1) and a second electrical connection terminal (T2), this current limiting dipole comprising a superconducting conductor (F1 to F15) wound so as to form a two-wire coil extending in a single plane, a layer of insulator (E1 to E11, H1) being arranged between two turns of said coil, said superconducting conductor (F1 to F15) consisting of at least four separate superconducting cables (C1 to C12) wound in parallel and arranged in at least two pairs, each of the pairs being formed of two of said superconducting cables (C1 to C12), the superconducting cables (C1 to C12) being connected to one another so that the superconducting conductor extends in at least two outward and return paths between the periphery and the center of the coil while connecting the first electrical connection terminal (T1) to the second electrical connection terminal (T2).

2. The current limiting dipole as claimed in claim 1, **characterized in that** each of the pairs is formed of a first and a second superconducting cable (C1 to C12) that are electrically connected to one another in a first connection area and **in that**, in a second connection area, the first superconducting cable of each pair is electrically connected to one of the superconducting cables of another pair, the second superconducting cable of each pair being connected to an electrical connection terminal (T1, T2) or to one of the superconducting cables of another pair, one of the connection areas being the center of the coil and the other of the connection areas being the periphery of the coil.

3. The current limiting dipole as claimed in either of claims 1 and 2, **characterized in that** at least one of the superconducting cables is interposed between the two superconducting cables that are each connected to one of the electric connection terminals (T1, T2).

4. The current limiting dipole as claimed in one of the preceding claims, **characterized in that** the two superconducting cables of one and the same pair are of the same length.

5. The current limiting dipole as claimed in one of the preceding claims, **characterized in that**, between the two superconducting cables connected to the connection terminals (T1, T2), the number of layers of insulator is superior or equal to the half of the total number of superconducting cables.

6. The current limiting dipole as claimed in one of the preceding claims, **characterized in that** the superconducting cables (C1 to C12) are connected to one another at the center of the coil, so as to form said pairs, by bridging loops (P1 to P6).

7. The current limiting dipole as claimed in claim 6, **characterized in that** said bridging loops (P1 to P6) are arranged side by side.

8. The current limiting dipole as claimed in claim 6, **characterized in that** said bridging loops (P1 to P6) are distributed over the inner contour of the coil.

9. The current limiting dipole as claimed in one of the preceding claims, **characterized in that** the superconducting conductor consists of 2N superconducting cables arranged in N pairs, N bridging loops in a first connection area of the coil and N-1 bridging loops in a second connection area of the coil, the first connection area and the second connection area of the coil being chosen from among the periphery and the center of the coil, N being greater than or equal to 2.

10. The current limiting dipole as claimed in claim 9, **characterized in that** the superconducting conductor comprises N bridging loops at the periphery of the coil, respectively at the center of the coil, and N-1 bridging loops at the center of the coil, respectively at the periphery of the coil.

11. The current limiting dipole as claimed in either of claims 9 and 10, **characterized in that** the superconducting conductor (F1 to F15) consists of 2N superconducting cables (C1 to C12) arranged in N pairs, N bridging loops (P1 to P6) at the center of the coil and N-1 bridging loops (B1 to B3) at the periphery of the coil.

12. The current limiting dipole as claimed in either of claims 9 and 10, **characterized in that** the superconducting conductor consists of 2N superconducting cables arranged in N pairs, N-1 bridging loops at the center of the coil and N bridging loops at the periphery of the coil.

13. The current limiting dipole as claimed in claim 11, **characterized in that** the superconducting conductor (F1, F3, F4) consists of four superconducting cables (C1 to C4) arranged in two pairs, two bridging loops (P1, P2) at the center of the coil and one bridging loop (B1) at the periphery of the coil.

14. The current limiting dipole as claimed in claim 13, **characterized in that** the two bridging loops (P1, P2) at the center of the coil are adjacent, and **in that** the bridging loop (B1) at the periphery of the coil is located between the two connection terminals (T1, T2).

15. The current limiting dipole as claimed in claim 14, **characterized in that**, within the coil, between the superconducting cable (C4) connected to one connection terminal (T2) and the adjacent superconducting cable (C1) that is connected to the other connection terminal (T1), the layer of insulator (H1) has a thickness greater than the other layers of insulator (E1 to E3).

16. The current limiting dipole as claimed in claim 13, **characterized in that** the two bridging loops (P1, P2) at the center of the coil are adjacent, and **in that** the bridging loop (B1) at the periphery of the coil bypasses a connection terminal (T1).

17. The current limiting dipole as claimed in claim 13, **characterized in that** the two bridging loops (P1, P2) at the center of the coil are concentric, and **in that** the bridging loop (B1) at the periphery of the coil bypasses a connection terminal (T1).

18. The current limiting dipole as claimed in claim 11, **characterized in that** the superconducting conductor (F5, F6, F7) consists of six superconducting cables (C1 to C6) arranged in three pairs, three bridging loops (P1, P2, P3) at the center of the coil and two bridging loops (B1, B2) at the periphery of the coil.

19. The current limiting dipole as claimed in claim 18, **characterized in that** the three bridging loops (P1, P2, P3) at the center of the coil are adjacent and **in that** the two bridging loops (B1, B2) at the periphery of the coil each bypass a connection terminal (T1, T2).

20. The current limiting dipole as claimed in claim 18, **characterized in that** two of the bridging loops (P2, P3) at the center of the coil are concentric and **in that** one of the bridging loops (B2) at the periphery of the coil is arranged between the two connection terminals (T1, T2).

21. The current limiting dipole as claimed in claim 18, **characterized in that** one of the bridging loops (P2) at the center of the coil diametrically passes through the center of the coil, the other two bridging loops (P1, P3) at the center of the coil being located on either side of said coil, and **in that** one of the bridging loops (B2) at the periphery of the coil is arranged between the two connection terminals (T1, T2).

22. The current limiting dipole as claimed in claim 11, **characterized in that** the superconducting conductor (L3; L8 to L11) consists of eight superconducting cables (C1 to C8) arranged in four pairs, four bridging loops (P1 to P4) at the center of the coil and three bridging loops (B1 to B3) at the periphery of the coil.

23. The current limiting dipole as claimed in claim 22, **characterized in that** the four bridging loops (P1 to P4) at the center of the coil are adjacent and **in that** one of the bridging loops (B1) at the periphery of the coil bypasses a connection terminal (T1) and another of the bridging loops (B2), and **in that** the third bridging loop (B3) at the periphery of the coil is located between the two connection terminals (T1, T2).

24. The current limiting dipole as claimed in claim 22, **characterized in that** two of the bridging loops (P1, P2) at the center of the coil are adjacent, the other two bridging loops (P3, P4) at the center of the coil being concentric, and **in that** two of the bridging loops (B2, B3) at the periphery of the coil are located between the two connection terminals (T1, T2).

25. The current limiting dipole as claimed in claim 22, **characterized in that** the four bridging loops (P1 to P4) at the center of the coil are adjacent and **in that** the three loops (B1 to B3) at the periphery of the coil are concentric and surround a connection terminal (T1, T2).

26. The current limiting dipole as claimed in one of the preceding claims, **characterized in that**:
the superconducting cables (C1 to C12) form a bundle that is wound on itself, one of the layers of insulator (H1) forming a bundle layer of insulator arranged between two windings of the bundle, whereas the other layers of insulator (E1 to E11) form cable layers of insulator that are each arranged between two superconducting cables, the bundle layer of insulator (H1) being located between two superconducting cables that are each connected to a connection terminal (T1, T2);
the current limiter comprises at least two layers of insulator of different thicknesses.

27. The current limiting dipole as claimed in claim 26, **characterized in that** it furthermore comprises at least two layers of insulator made of a different material.

28. The current limiting dipole as claimed in one of the preceding claims, **characterized in that** the layer of insulator located between two superconducting cables whose potential difference is the lowest, when the current limiting dipole becomes resistive, has a thickness less than that of the other layers of insulator.

29. The current limiting dipole as claimed in one of the preceding claims, **characterized in that** the layer of insulator located between two superconducting cables whose potential difference is the highest, when the current limiting dipole becomes resistive, has a thickness greater than that of the other layers of insulator.

30. The current limiting dipole as claimed in one of the preceding claims, **characterized in that** the bundle layer of insulator (H1) has a thickness greater than the cable layers of insulator (E1 to E11).

31. The current limiting dipole as claimed in one of the preceding claims, **characterized in that** the bundle layer of insulator (H1) has a thickness greater than 2/3 of the sum of the thicknesses of the cable layers of insulator (E1 to E11).

32. The current limiting dipole as claimed in one of claims 26 to 30, **characterized in that** the bundle layer of insulator (H1) has a thickness greater than 1.5 times the thickness of a cable layer of insulator (E1 to E11).

33. The current limiting dipole as claimed in claim 30, **characterized in that**, with the cables being in a number of 2n, the bundle layer of insulator (H1) has a thickness of the order of n times the thickness of a cable layer of insulator (E1 to E11).

34. The current limiting dipole as claimed in one of claims 2 to 33, **characterized in that** the first connection area is located at the center of the coil, and **in that** the second connection area is located at the periphery of the coil.

35. The current limiting dipole as claimed in one of claims 2 to 33, **characterized in that** the first connection area is located at the periphery of the coil, and **in that** the second connection area is located at the center of the coil.

36. The current limiting dipole as claimed in either of claims 34 and 35, **characterized in that** it comprises four superconducting cables (C1 to C4) arranged in two pairs, two bridging loops (P1, P2) in a first connection area, a bridging loop (B1) at the level of a second connection area, and two connection terminals (T1, T2), the first connection area and the second connection area of the coil being chosen from among the periphery and the center of the coil, the bundle layer of insulator (H1) being located between two superconducting cables that are each connected to a connection terminal (T1, T2).

37. The current limiting dipole as claimed in either of claims 34 and 35, **characterized in that** it comprises six superconducting cables (C1 to C6) arranged in three pairs, three bridging loops (P1 to P3) in a first connection area, two bridging loops (B1, B2) in a second connection area, and two connection terminals (T1, T2), the first connection area and the second connection area of the coil being chosen from among the periphery and the center of the coil, the bundle layer of insulator (H1) being located between two superconducting cables that are each connected to a connection terminal (T1, T2).

38. The current limiting dipole as claimed in either of claims 34 and 35, **characterized in that** it comprises eight superconducting cables (C1 to C8) arranged in four pairs, four bridging loops (P1 to P4) in a first connection area, three bridging loops (B1 to B3) in a second connection area, and two connection terminals (T1, T2), the first connection area and the second connection area of the coil being chosen from among the periphery and the center of the coil, the bundle layer of insulator (H1) being located between two superconducting cables that are each connected to a connection terminal (T1, T2).
